(19) Europäisches Patentamt
European Patent Office
Office européen des brevets

(11) EP 2 484 535 B1

(12) **EUROPEAN PATENT SPECIFICATION**

(45) Date of publication and mention of the grant of the patent:
**10.12.2014 Bulletin 2014/50**

(21) Application number: **10818608.1**

(22) Date of filing: **07.07.2010**

(51) Int Cl.:
***B41N 1/14*** *(2006.01)*
***G03F 7/00*** *(2006.01)*
***G03F 7/033*** *(2006.01)*
***G03F 7/11*** *(2006.01)*
***B41C 1/10*** *(2006.01)*
***G03F 7/09*** *(2006.01)*
***G03F 7/30*** *(2006.01)*

(86) International application number:
**PCT/JP2010/061544**

(87) International publication number:
**WO 2011/036931 (31.03.2011 Gazette 2011/13)**

(54) **LITHOGRAPHIC PRINTING PLATE PRECURSOR AND PROCESS FOR PRODUCING SAME**

LITHOGRAPHIEDRUCKPLATTENVORLÄUFER UND HERSTELLUNGSVERFAHREN DAFÜR

PRÉCURSEUR DE PLAQUE D'IMPRESSION LITHOGRAPHIQUE ET SON PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **28.09.2009 JP 2009223407**

(43) Date of publication of application:
**08.08.2012 Bulletin 2012/32**

(73) Proprietor: **FUJIFILM Corporation**
**Tokyo 106-0031 (JP)**

(72) Inventor: **SONOKAWA Koji**
**Haibara-gun, Shizuoka (JP)**

(74) Representative: **Hoffmann Eitle**
**Patent- und Rechtsanwälte PartmbB**
**Arabellastraße 30**
**81925 München (DE)**

(56) References cited:
**EP-A2- 1 518 672**
**JP-A- 2007 272 120**
**JP-A- 2009 073 089**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 484 535 B1

## Description

TECHNICAL FIELD

The present invention relates to a lithographic printing plate precursor and a plate making method using the same. More particularly, it relates to a lithographic printing plate precursor capable of undergoing a direct plate making by image exposure with laser and a plate making method comprising on-press development of the lithographic printing plate precursor.

BACKGROUND ART

In general, a lithographic printing plate is composed of an oleophilic image area accepting ink and a hydrophilic non-image area accepting dampening water in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.

In order to produce the lithographic printing plate, a lithographic printing plate precursor (PS plate) comprising a hydrophilic support having provided thereon an oleophilic photosensitive resin layer (image-recording layer) is used. Specifically, the PS plate is exposed through a mask, for example, a lith film, and then subjected to development processing, for example, with an alkaline developer to remove the unnecessary image-recording layer corresponding to the non-image area by dissolving while leaving the image-recording layer corresponding to the image area, thereby obtaining the lithographic printing plate.

Due to the recent progress in the technical field, nowadays the lithographic printing plate can be obtained by a CTP (computer-to-plate) technology. Specifically, a lithographic printing plate precursor is directly subjected to scanning exposure using laser or laser diode without using a lith film and developed to obtain a lithographic printing plate.

With the progress described above, the issue on the lithographic printing plate precursor has transferred to improvements, for example, in image-forming property corresponding to the CTP technology, printing property or physical property. Also, with the increasing concern about global environment, as another issue on the lithographic printing plate precursor, an environmental problem on waste liquid discharged accompanying the wet treatment, for example, development processing comes to the front.

In response to the environmental problem, simplification of development or plate making or non-processing has been pursued. As one method of simple plate making, a method referred to as an "on-press development" is practiced. Specifically, according to the method after exposure of a lithographic printing plate precursor, the lithographic printing plate precursor is mounted as it is on a printing machine without conducting conventional development and removal of the unnecessary area of image-recording layer is performed at an early stage of printing process.

Also, as a method of simple development, a method referred to as a "gum development" is practiced wherein the removal of the unnecessary area of image-recording layer is performed using not a conventional highly alkaline developer but a finisher or gum solution of near-neutral pH.

In the simplification of plate making operation as described above, a system using a lithographic printing plate precursor capable of being handled in a bright room or under a yellow lamp and a light source is preferred from the standpoint of workability. Thus, as the light source, a semiconductor laser emitting an infrared ray having a wavelength of 760 to 1,200 or a solid laser, for example, YAG laser, is used. An UV laser is also used.

As the lithographic printing plate precursor capable of undergoing on-press development, for instance, a lithographic printing plate precursor having provided on a hydrophilic support, an image-recording layer (heat-sensitive layer) containing microcapsules having a polymerizable compound encapsulated therein is described in Patent Document 1 or 2. A lithographic printing plate precursor having provided on a support, an image-recording layer (photosensitive layer) containing an infrared absorbing agent, a radical polymerization initiator and a polymerizable compound is described in Patent Document 3. A lithographic printing plate precursor capable of undergoing on-press development having provided on a support, an image-recording layer containing a polymerizable compound and a graft polymer having a polyethylene oxide chain in its side chain or a block polymer having a polyethylene oxide block is described in Patent Document 4.

In case of using the polymerization reaction, it is known as a usual practice to provide an overcoat layer (protective layer) having an oxygen blocking property on the photosensitive layer in order to prevent polymerization inhibition due to oxygen in the air and to increase sensitivity and printing durability. It is conventionally known that a water-soluble resin, for example, polyvinyl alcohol is used in the overcoat layer for the purpose described above. A lithographic printing plate precursor of on-press development type provided with an overcoat layer using a modified

polyvinyl alcohol is described in Patent Document 5. Also, a lithographic printing plate precursor provided with an overcoat layer using an inorganic stratiform compound having an oxygen blocking property, for example, mica and a water-soluble resin is described in Patent Document 6.

In the conventional alkali-development system, since the overcoat layer is completely removed in a development process by means of a brush or the like, it does not adversely affect at all on a printing process. However, in the on-press development system, when the overcoat layer mainly composed of polyvinyl alcohol as described in Patent Document 5 is used, since the polyvinyl alcohol has high crystallinity and a relatively thick overcoat layer is provided in order to obtain the desired oxygen blocking property, there are problems in that it takes long time for the overcoat layer to be removed at the on-press development and in that a large amount of the polyvinyl alcohol removed is mixed into dampening water to deteriorate running aptitude of on-press development, for example, due to the deposition on an impression cylinder. On the other hand, in case of using the inorganic stratiform compound, for example, mica as described in Patent Document 6, the desired oxygen blocking property can be obtained by a relatively thin overcoat layer. However, there are problems when the inorganic stratiform compounds densely overlap each other in the overcoat layer, water permeation at the on-press development slows down to take long time for the on-press development and in that due to the water permeability which is a feature of the photosensitive layer capable of undergoing on-press development, interfacial mixing partially arises at the coating and drying of the overcoat layer and the inorganic stratiform compound having high hydrophilicity remains on the surface of photosensitive layer after the on-press development to result in lowering of ink receptivity at the printing after the on-press development.

In document EP-A-1 518 672 a lithographic printing plate precursor and a lithographic printing plate method are disclosed wherein the printing plate precursor comprises a support, an image recording layer which contains an actinic ray absorber (A), a polymerization initiator (B), and a polymerizable compound (C); it is disclosed that the image recording layer can be removed by supplying printing ink and a fountain solution after exposure with laser beams, and an overcoat layer, wherein the overcoat layer comprises an inorganic laminar, i.e. a stratiform compound.

PRIOR ART DOCUMENT

PATENT DOCUMENT

Patent Document 1: JP-A-2001-277740
Patent Document 2: JP-A-2001-277742
Patent Document 3: JP-A-2002-287334
Patent Document 4: U.S. Patent Publication No. 2003/0064318
Patent Document 5: JP-A-2005-271284
Patent Document 6: JP-A-2005-119273

DISCLOSURE OF THE INVENTION

PROBLEMS THAT THE INVENTION IS TO SOLVE

An object of the present invention is to provide a lithographic printing plate precursor of on-press development type which is excellent in all performances of on-press development property, ink receptivity, sensitivity and printing durability and a plate making method thereof.

MEANS FOR SOLVING THE PROBLEMS

(1) A lithographic printing plate precursor comprising a support, an image-recording layer which contains (A) an infrared absorbing agent, (B) a radical polymerization initiator and (C) a radical polymerizable compound and in which an unexposed area can be removed by supplying printing ink and dampening water after exposure, and an overcoat layer in this order, wherein the overcoat layer contains at least two kinds of inorganic stratiform compounds having different crystal structures.

(2) The lithographic printing plate precursor as described in (1) above, wherein at least one kind of the inorganic stratiform compounds is a layered silicate compound.

(3) The lithographic printing plate precursor as described in (1) or (2) above, wherein at least two kinds of the inorganic stratiform compounds are layered silicate compounds in which layer structures composed of a tetrahedral

sheet and an octahedral sheet are different from each other.

(4) The lithographic printing plate precursor as described in (3) above, wherein the layer structures composed of a tetrahedral sheet and an octahedral sheet in at least two kinds of the inorganic stratiform compounds are 1 : 1 type and 2 : 1 type.

(5) The lithographic printing plate precursor as described in (4) above, wherein the 1 : 1 type inorganic stratiform compound is a kaolin subgroup.

(6) The lithographic printing plate precursor as described in (4) above, wherein the 2 : 1 type inorganic stratiform compound is at least one kind selected from a swellable synthetic mica, a smectite group and a vermiculite group.

(7) The lithographic printing plate precursor as described in any one of (1) to (6) above, wherein the image-recording layer further contains (D) a binder polymer.

(8) The lithographic printing plate precursor as described in (7) above, wherein the binder polymer (D) is a copolymer having an alkylene oxide structure in its side chain.

(9) The lithographic printing plate precursor as described in any one of (1) to (8) above, wherein the image-recording layer further contains a polymer fine particle.

(10) The lithographic printing plate precursor as described in (9) above, wherein the polymer fine particle has a polyalkylene oxide structure in its side chain.

(11) The lithographic printing plate precursor as described in (9) or (10) above, wherein the polymer fine particle contains a microcapsule or a microgel.

(12) A plate making method of a lithographic printing plate precursor comprising a step of exposing imagewise the lithographic printing plate precursor as described in any one of (1) to (11) above and a step of removing an unexposed area of the image-recording layer of the lithographic printing plate precursor by supplying oily ink and dampening water on a printing machine to initiate printing without subjecting any development processing to the exposed lithographic printing plate precursor.

According to the invention, the on-press development property and ink receptivity can be improved while maintaining the sensitivity and printing durability in a level of a conventional inorganic stratiform compound-containing overcoat layer by means of using at least two kinds of inorganic stratiform compounds having different crystal structures in the overcoat layer.

The functional mechanism of the invention is not quite clear but it is estimated as follows.

It is believed that by means of using at least two kinds of inorganic stratiform compounds having different crystal structures, while maintaining the oxygen blocking effect at the exposure the overcoat layer becomes easily swellable with dampening water at the on-press development to promote permeation of water necessary for the on-press development, to increase the on-press development removability of the overcoat layer, and to decrease the residual amount of the inorganic stratiform compound on the surface of the photosensitive layer after the on-press development, whereby the ink receptivity can be improved.

Specifically, it is believed that the key point of the invention is to make irregular the overlap state of the inorganic stratiform compounds at the coating and drying of the overcoat layer by blending the inorganic stratiform compounds having different crystal structures.

## ADVANTAGE OF THE INVENTION

According to the present invention, a lithographic printing plate precursor of on-press development type which is excellent in on-press development property and ink receptivity and exhibits excellent sensitivity and printing durability, and a plate making method thereof can be provided.

## MODE FOR CARRYING OUT THE INVENTION

### [Lithographic printing plate precursor]

The lithographic printing plate precursor according to the invention essentially comprises an image-recording layer capable of undergoing on-press development on a support and an overcoat layer on the image-recording layer. The lithographic printing plate precursor according to the invention may comprise an undercoat layer between the support and the image-recording layer, an intermediate layer between the image-recording layer and the overcoat layer or a back layer on the surface of the support opposite to the image-recording layer, if desired.

Hereinafter, the constituting element, component and the like of the lithographic printing plate precursor according to the invention will be described.

(Overcoat layer)

The lithographic printing plate precursor according to the invention is essentially provided with an overcoat layer (protective layer) containing inorganic stratiform compounds on an image-recording layer and the inorganic stratiform compounds comprise at least two kinds of inorganic stratiform compounds having different crystal structures. The overcoat layer has a function for restraining an inhibition reaction against the image formation by means of oxygen blocking.

Ordinarily, the exposure is performed in the air in the invention. The overcoat layer prevents a low molecular weight compound, for example, oxygen or a basic substance present in the air, which inhibits the image-forming reaction occurred upon the exposure in the image-recording layer from penetrating into the image-recording layer and as a result, the inhibition of image-forming reaction at the exposure in the air can be restrained. Accordingly, the characteristic required of the overcoat layer is to reduce permeability of the low molecular weight compound, for example, oxygen. Further, the overcoat layer preferably has good transparency to light used for the exposure, is excellent in an adhesion property to the image-recording layer, and can be easily removed during the on-press development processing step after the exposure. With respect to the overcoat layer having such properties, various investigations have been made heretofore and there are described in detail, for example, in U.S. Patent 3,458,311 and JP-B-55-49729.

<Inorganic stratiform compound and crystal structure of inorganic stratiform compound>

The inorganic stratiform compound for use in the invention means an inorganic compound having a layered structure in which unit crystal layers are stacked on each other as described in Japanese Patent 3298317. In other words, the stratiform compound is a compound or substance having a layered structure and the layered structure means a structure in which planes of atoms which are strongly connected, for example, by covalent bonds and densely arrayed are stacked almost parallel to each other by a weak bonding force, for example, van der Waals' force. Specific examples of the inorganic stratiform compound include graphite, a phosphate-based derivative type compound (zirconium phosphate-based compound), a chalcogenide [dichalcogenide of IV group (Ti, Zr or Hf), V group (V, Nb or Ta) and/or VI group (Mo or W) which is represented by formula $MX_2$ wherein M represents the element described above, and X represents chalcogen (S, Se or Te)], a hydrotalcite compound, a lithium aluminum complex hydroxide and a layered silicate compound of clay mineral.

Of the compounds, the layered silicate compound is preferred from the standpoint of versatility, economy, transparency to a light source for forming an image and the like. The silicate compounds (minerals) are largely classified depending on the state of silicate ion included therein into a nesosilicate compound in which a silicate ion is present alone, a solosilicate compound in which silicate ions are present as a pair, a cyclosilicate compound in which silicate ions are present in a circular form, an inosilicate compound in which silicate ions are present in a chain-like form, a phillosilicate compound (layered silicate compound) in which silicate ions are present in a layered form, and a tectosilicate compound in which silicate ions are present in a steric form (three dimensional form).

Among them, the layered silicate compounds which can be preferably used in the invention are classified into a type composed of two-layer structure in which an octahedral sheet having aluminum, magnesium or the like as a central metal is present on a tetrahedral sheet of silica, that is, a so-called 1 : 1 type layer structure, a type composed of three-layer structure in which an octahedral sheet having aluminum, magnesium or the like as a central metal is sandwiched between two tetrahedral sheets of silica, that is, a so-called 2 : 1 type layer structure, and a 2 : 1 : 1 type layer structure in which an octahedral sheet having aluminum, magnesium or the like as a central metal is interposed as a sole layer between the layers of the 2 : 1 type layer structure.

The layered silicate compounds are subdivided into several groups depending on the layer structure described above and a layer charge per unit composition formula. Each of the groups is further divided into 2 to 3 subgroups according to the kind of octahedral sheet, specifically, a dioctahedral sheet having aluminum or iron (III) as a central metal or a trioctahedral sheet having magnesium, lithium, nickel, iron (II) or manganese as a central metal, and in each of the subgroups there are species having a name which is conventionally used as a name for mineral.

Specifically, the 1 : 1 type layer structure includes serpentine-kaolin group, and serpentine subgroup of trioctahedral sheet includes lizardite, amesite, chrysotile and the like as a representative species and kaolin sub group of dioctahedral sheet includes kaolinite, dickite, halloysite and the like as a representative species.

The 2 : 1 type layer structures are classified into talc-pyrophyllite group having the layer charge per unit composition formula of almost 0, smectite group having that of 0.2 to 0.6, vermiculite group having that of 0.6 to 0.9, mica group having that of 0.6 to 1.0, and brittle mica group having that of 1.8 to 2.0. The 2 : 1 : 1 type layer structure includes chlorite group in which the layer charge is varied. As the representative species, the talc-pyrophyllite group includes talc, pyrophyllite and the like, the smectite group includes saponite, hectorite, sauconite, stevensite, montmorillonite, bandylite, nontronite and the like, the vermiculite group includes trioctahedral type vermiculite, dioctahedral type vermiculite and the like, the mica group includes phlogopite, biotite, lepidolite, illite, muscovite, paragonite and the like, the

brittle mica group includes clintonite, margarite and the like, and the chlorite group includes clinochlore, chamosite, nimite, donbassite, cookeite, sudoite and the like.

In addition to the natural minerals as described above, synthetic mica, synthetic smectite and the like can also usefully employed as the inorganic stratiform compound according to the invention. These compounds are also classified into the 2 : 1 type layer structure. The synthetic mica includes fluorophlogopite, K tetrasilicic fluormica, Na tetrasilicic fluormica, Na taeniolite, Li taeniolite and the like. The synthetic smectite includes synthetic saponite, Na hectorite, Li hectorite and the like.

Of the inorganic stratiform compounds, a swellable synthetic mica, a swellable clay mineral, for example, montmorillonite, saponite or hectorite, and the like have a layer structure unit having thickness of approximately from 10 to 15 angstroms, and metallic atom substitution in the lattices thereof is remarkably large in comparison with other clay minerals. As a result, the lattice layer results in lack of positive charge and to compensate it, a cation, for example, $Li^+$, $Na^+$, $Ca^{2+}$ or $Mg^{2+}$ is adsorbed between the lattice layers. The cation intervening between the layers is called an exchangeable cation and is exchanged with various cations. Particularly, in the case where the cation between the layers is $Li^+$ or $Na^+$, since the ionic radius is small, the bond between the layer structures is weak, thereby greatly swelling with water. When share is applied under such a condition, they are easily cleaved to form a stable sol in water. The swellable synthetic mica strongly shows this tendency and is particularly preferably used in the invention.

As for a synthetic method of the synthetic mica, the synthetic method is devised corresponding to the occurrence of natural mica. The occurrences of mica in nature are largely classified into three groups. One is melt growth found in igneous rock, for example, granite or pegmatite as represented by muscovite, biotite or phlogopite. Another is contact degeneration found in metamorphic rock, for example, gneiss or hornfels as in biotite or phlogopite. The last is hydrothermal alteration in which the stratum weathers with hot water found in sericite (mineralogically, illite). To the hydrothermal alteration is applied hydrothermal synthesis. To the contact degeneration is applied solid-phase reaction synthesis. To the melt growth is applied fused synthesis. The hydrothermal synthesis is a method of conducting solution growth using liquid glass, aluminum hydroxide, magnesium hydroxide or the like as a raw material in an autoclave. The characteristic of this method is that OH type mica is obtained because of an aqueous reaction under a high pressure. The solid-phase reaction synthesis is a synthesis method in which talc having the same 2 : 1 type structure is used as a host and mixed with an alkali silicon fluoride followed by being subjected to thermal treatment to convert into mica by topotaxy. The characteristics of this method are that the synthesis can be carried out by the thermal treatment at low temperature of 1,000°C or below, that an impurity is relatively small, that a particle size of the mica formed can be controlled according to a particle size of the talc used as a starting material, and that the synthetic product is obtained as powder. Since the solid-phase reaction synthesis is a reaction carried out at a normal pressure, the mica obtained is all fluorine mica, and since the talc is used as the host, the species of mica obtained is only tetrasilicic mica. The hydrothermal synthesis is a synthesis method in which an industrial material, for example, silica sand ($SiO_2$), magnesium oxide (MgO), aluminum oxide ($Al_2O_3$), potassium silicofluoride ($K_2SiF_6$) or sodium silicofluoride ($Na_2SiF_6$) is heated to melt at about 1, 500°C and cooled to crystallize. The characteristics of this method are that since the temperature of the reaction system is high, the yield is high, that since the starting material is completely molted, the uniformity of the system is high to obtain high purity crystals, and that OH type mica can not be formed and the mica obtained is all fluorine mica because of the synthesis method carried out at a normal pressure.

With respect to the clay mineral, reference can be made to Nendo Kisokoza I described in the Homepage of The Clay Science Society of Japan (http://wwwsoc.nii.ac.jp/cssj2/seminar1/section01/text.hml) and literature, for example, Masahiro Maeno, Sokogasiritai Nendo no Kagaku, The Nikkan Kogyo Shimbun, Ltd. (1993) or Haruo Shirouzu, Nendo Kobutsugaku, Asakura Publishing Co., Ltd. (1988).

Also, in addition to the layered silicate compound of the clay mineral described above, zirconium phosphate can be usefully employed in the invention. The zirconium phosphate has a layered structure in which hydrogen phosphoric acid groups are bonded above and below a hexagonal net made of zirconium. Therefore, it is known that various organic compounds are intercalated between the layers of zirconium phosphate (Clays and Clay Minerals, vol. 23, pages 477 (1975)). It is also reported that a phosphoric acid group between the layers of zirconium phosphate is alkyl-esterified by an exchange reaction with a monoalkyl phosphate (J. Inorg. Nucl. Chem., vol. 43, page 1343 (1981) and that when an epoxide is used, the hydrogen phosphoric acid group nucleophilically attacks the epoxide between the layers to provide a corresponding ethylene glycol phosphate ester derivative (Inorg. Chem., vol 15, page 2811 (1976)).

<Addition of two kinds of inorganic stratiform compounds to overcoat layer>

The present invention is characterized in that the overcoat layer contains at least two kinds of inorganic stratiform compounds having different crystal structures among the inorganic stratiform compounds described above. The inorganic stratiform compound is preferably the layered silicate compound from the standpoint of oxygen blocking property, that is, sensitivity and printing durability. Specifically, preferably at least one kind, more preferably two kinds, most preferably all kinds of the inorganic stratiform compounds used are the layered silicate compounds. In case of using only the layered

silicate compounds, it is necessary to use a combination of the layered silicate compounds having different layer structures which comprises a tetrahedral sheet and an octahedral sheet. The combinations include three types, a combination of 1 : 1 type layer structure with 2 : 1 type layer structure, a combination of 1 : 1 type layer structure with 2:1:1 type layer structure and a combination of 2 : 1 type layer structure with 2:1:1 type layer structure. Among them, the combination of 1 : 1 type layer structure with 2 : 1 type layer structure is preferred from the standpoint of sensitivity and printing durability. The reason for this is believed to be that the effects of the invention are easily exhibited when the inorganic stratiform compounds used in the invention are cleaved as much as possible in a coating solution for overcoat layer and two kinds of the inorganic stratiform compounds having different crystal structures are well mixed each other. As the layered silicate compound having such a characteristic, specifically, of the 1 : 1 type layer structures the kaolin subclass is preferred, especially kaolinite or halloysite is more preferred because of low crystallinity, and kaolinite is most preferred. Of the 2 : 1 type layer structures, the smectite group, the vermiculite group or the synthetic mica is preferred in view of the swellability in water, saponite, montmorillonite, hectorite, Na tetrasilicic fluormica, Na taeniolite or Na hectorite is particularly preferred, and montmorillonite or Na tetrasilicic fluormica is most preferred. The most preferred combination of the inorganic stratiform compounds according to the invention includes a combination of kaolinite with Na tetrasilicic fluormica, a combination of kaolinite with montmorillonite and a combination of kaolinite with vermiculite and these combinations exhibit the large effects of the invention.

As for the shape of the inorganic stratiform compound for use in the invention, from the standpoint of control of diffusion, the thinner the thickness or the larger the plain size as long as smoothness of coated surface and transmission of actinic radiation are not damaged, the better. Therefore, an aspect ratio of the inorganic stratiform compound is preferably 10 or more, more preferably 100 or more, and particularly preferably 200 or more. The aspect ratio is a ratio of major axis to thickness of particle and can be determined, for example, from a projection drawing of particle by a microphotography. The larger the aspect ratio, the greater the oxygen blocking effect.

As for a particle diameter of the inorganic stratiform compound for use in the invention, the average major axis thereof is preferably from 0.3 to 20 μm, more preferably from 0.5 to 10 μm, and particularly preferably from 1 to 5 μm. The average thickness of the particle is preferably 0.1 μm or less, more preferably 0.05 μm or less, and particularly preferably 0.01 μm or less. For example, with respect to the swellable synthetic mica which is the representative compound of the inorganic stratiform compound, the thickness is approximately from 1 to 50 nm and the plain size is approximately from 1 to 20 μm.

The specific total amount of the inorganic stratiform compounds can not be generally defined because it is varied depending on the inorganic stratiform compounds to be used, but it is preferably from 1 to 70% by weight, more preferably from 20 to 60% by weight, based on the total solid content of the overcoat layer. In the range described above, more preferred effect for preventing adherence and scratch and maintenance of preferred printing durability are obtained.

As for a mixing ratio of at least two kinds of the inorganic stratiform compounds having different crystal structures, as the amounts of the compounds added come closer to each other, the effects of the invention are preferably more easily obtained.

Specifically, in case of mixing two kinds the mixing ratio is preferably from 20/80 to 80/20, more preferably from 30/70 to 70/30 and most preferably from 40/60 to 60/40. In case of mixing three kinds the mixing ratio is preferably from 20/20/60, 20/60/20 to 60/20/20, and more preferably from 30/30/40, 30/40/30 to 40/30/30. When the compounds having the same crystal structure are used, the amounts thereof are totalized to determine the mixing ratio.

<Binder>

In the overcoat layer according to the invention, a binder is preferably used together with the inorganic stratiform compound described above.

The binder is not particularly restricted as long as it has good dispersibility of the inorganic stratiform compound and is capable of forming a uniform layer which adheres to the image-recording layer, and any water-soluble polymer and water-insoluble polymer can be appropriately selected to use. Specifically, for example, a water-soluble polymer, for example, polyvinyl alcohol, a modified polyvinyl alcohol, polyvinyl pyrrolidone, polyvinyl imidazole, polyacrylic acid, polyacrylamide, a partially saponified product of polyvinyl acetate, an ethylene-vinyl alcohol copolymer, a water-soluble cellulose derivative, gelatin, a starch derivative or gum arabic, and a polymer, for example, polyvinylidene chloride, poly(meth)acrylonitrile, polysulfone, polyvinyl chloride, polyethylene, polycarbonate, polystyrene, polyamide or cellophane are exemplified. The polymers may be used in combination of two or more thereof, if desired.

Of the polymers, from the standpoint of easy removability of the overcoat layer remaining in the non-image area and handling property at the time of forming a layer, a water-soluble polymer is preferred and, for example, polyvinyl alcohol, a modified polyvinyl alcohol, polyvinyl pyrrolidone, polyvinyl imidazole, a water-soluble acrylic resin, for example, polyacrylic acid, gelatin or gum arabic is preferably used. Above all, polyvinyl alcohol, a modified polyvinyl alcohol, polyvinyl pyrrolidone, gelatin or gum arabic is more preferably used from the standpoint of capability of coating with water as a solvent and easiness of removal with dampening water at the printing.

The polyvinyl alcohol for use in the overcoat layer according to the invention may be partially substituted with an ester, an ether or an acetal as long as it contains a substantial amount of unsubstituted vinyl alcohol units necessary for maintaining water solubility. Also, the polyvinyl alcohol may partially contain other copolymerization components. Specific examples of the polyvinyl alcohol include those being hydrolyzed 71 to 100% by mole and having a polymerization degree of 300 to 2,400.

Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, produced by Kuraray Co., Ltd. are exemplified. As the copolymer described above, polyvinyl acetatechloroacetate or propionate, polyvinyl formal and polyvinyl acetal and copolymers thereof each hydrolyzed from 88 to 100% by mole are exemplified.

Also, a known modified polyvinyl alcohol can be preferably used. For instance, polyvinyl alcohols of various polymerization degrees having at random a various kind of hydrophilic modified cites, for example, an anion-modified cite modified with an anion, e.g., a carboxyl group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer chain a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are exemplified. From the standpoint of on-press development property, polyvinyl alcohol having an anion-modified cite is preferred, and polyvinyl alcohol modified with an anion of sulfo group is particularly preferred.

<Preparation of coating solution and formation of overcoat layer>

An example of ordinary dispersing method of the inorganic stratiform compound is described below. Specifically, from 5 to 10 parts by weight of a swellable stratiform compound which is exemplified as the preferred organic stratiform compound above is added to 100 parts by weight of water to adapt the compound to water and to be swollen, followed by dispersing using a dispersing machine. The dispersing machine used include, for example, a variety of mills conducting dispersion by directly applying mechanical power, a high-speed agitation type dispersing machine providing a large shear force and a dispersion machine providing ultrasonic energy of high intensity. Specific examples thereof include a ball mill, a sand grinder mill, a visco mill, a colloid mill, a homogenizer, a dissolver, a polytron, a homomixer, a homoblender, a keddy mill, a jet agitor, a capillary type emulsifying device, a liquid siren, an electromagnetic strain type ultrasonic generator and an emulsifying device having Polman whistle. A dispersion containing from 5 to 10% by weight of the inorganic stratiform compound dispersed according to the method described above is highly viscous or gelled and exhibits extremely good preservation stability. In the preparation of a coating solution for overcoat layer using the dispersion, it is preferred that the dispersion is diluted with water, sufficiently stirred and then mixed with a binder solution.

To the coating solution for overcoat layer can be added known additives, for example, a surfactant for improving the coating property or a water-soluble plasticizer for improving the physical property of the layer. As the surfactant, a nonionic surfactant or an anionic surfactant is preferably used. As the water-soluble plasticizer, for example, propionamide, cyclohexane diol, glycerin and sorbitol are exemplified. Also, a water-soluble (meth) acrylic polymer may be added. Further, to the coating solution may be added known additives for improving adhesion property to the image-recording layer or time-lapse stability of the coating solution.

The coating solution for overcoat layer thus-prepared is coated on the image-recording layer provided on the support and dried to form an overcoat layer. The coating solvent may be appropriately selected in view of the binder used, and when a water-soluble polymer is used, distilled water or purified water is preferably used. A coating method of the overcoat layer is not particularly limited, and known methods, for example, methods described in U.S. Patent 3,458,311 and JP-B-55-49729 can be utilized. Specifically, in the formation of overcoat layer, for example, a blade coating method, an air knife coating method, a gravure coating method, a roll coating method, a spray coating method, a dip coating method or a bar coating method is exemplified.

The coating amount of the overcoat layer is preferably in a range from 0.01 to 4 $g/m^2$, more preferably in a range from 0.02 to 2 $g/m^2$, most preferably in a range from 0.05 to 1 $g/m^2$, in terms of coating amount after drying.

(Image-recording layer)

The image-recording layer for use in the invention is essentially an image-recording layer capable of undergoing on-press development. As a representative image-forming embodiment capable of undergoing on-press development which the image-recording layer includes, an embodiment which contains (A) an infrared absorbing agent, (B) a radical polymerization initiator and (C) a radical polymerizable compound and in which the image area is cured utilizing a polymerization reaction is exemplified. Also, a polymer fine particle may be incorporated into the image-recording layer

of polymerization type described above. The polymer fine particle may have a property of turning hydrophobic utilizing heat fusion or heat reaction (such a polymer fine particle is also referred to as a hydrophobilizing precursor).

The image-recording layer for use in the invention is essentially an image-recording layer capable of undergoing on-press development. As a representative image-forming embodiment capable of undergoing on-press development which the image-recording layer includes, (1) an embodiment which contains (A) an infrared absorbing agent, (B) a radical polymerization initiator and (C) a radical polymerizable compound and in which the image area is cured utilizing a polymerization reaction and (2) an embodiment which contains (A) an infrared absorbing agent and (E) a polymer fine particle and in which a hydrophobic region (image area) is formed utilizing heat fusion or heat reaction of the polymer fine particle (such a polymer fine particle is also referred to as a hydrophobilizing precursor) are exemplified. A mixture of these two embodiments may also used. For instance, the polymer fine particle may be incorporated into the image-recording layer of polymerization type (1) or the radical polymerizable compound or the like may be incorporated into the image-recording layer of hydrophobilizing precursor type containing the polymer fine particle (2). Among them, the embodiment of polymerization type containing the infrared absorbing agent (A), radical polymerization initiator (B) and polymerizable compound (C) is preferred.

Respective components which can be incorporated into the image-recording layer will be described in order below.

(A) Infrared absorbing agent

The infrared absorbing agent has a function of converting the infrared ray absorbed to heat and a function of being excited by the infrared ray to perform electron transfer and/or energy transfer to a radical polymerization initiator described hereinafter. The infrared absorbing agent for use in the invention is a dye having an absorption maximum in a wavelength range from 760 to 1,200 nm or the like.

As the infrared absorbing dye, compounds described in Paragraph Nos. [0058] to [0087] of JP-A-2008-195018 can be used.

Of the dyes, a dye, a squarylium dye, a pyrylium dye and a nickel thiolate complexes are particularly preferred. As the particularly preferred example of the dye, a cyanine dye represented by formula (a) shown below is exemplified.

Formula (a)

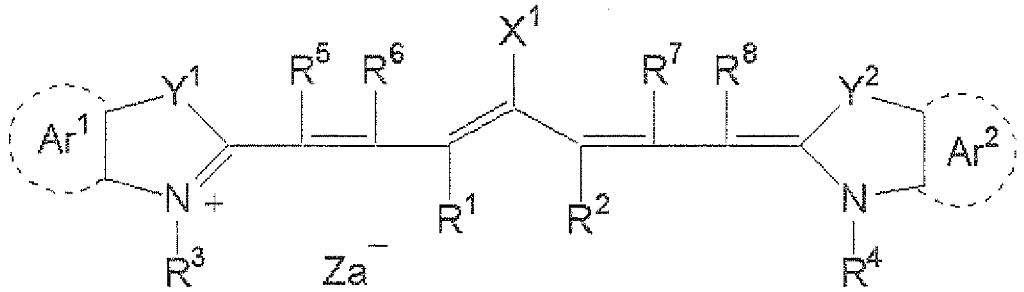

In formula (a), $X^1$ represents a hydrogen atom, a halogen atom, $-N(R^9)(R^{10})$, $X^2$-$L^1$ or a group shown below. $R^9$ and $R^{10}$, which may be the same or different, each represents an aromatic hydrocarbon group having from 6 to 10 carbon atoms, which may have a substituent, an alkyl group having from 1 to 8 carbon atoms, which may have a substituent or a hydrogen atom, or $R^9$ and $R^{10}$ may be combined with each other to form a ring. Among them, a phenyl group is preferred. $X^2$ represents an oxygen atom or a sulfur atom, $L^1$ represents a hydrocarbon group having from 1 to 12 carbon atoms, an aromatic ring group containing a hetero atom or a hydrocarbon group having from 1 to 12 carbon atoms and containing a hetero atom. The hetero atom as used herein indicates a nitrogen atom, a sulfur atom, an oxygen atom, a halogen atom or a selenium atom. In the group shown below, $Xa^-$ has the same meaning as $Za^-$ defined hereinafter, and $R^a$ represents a hydrogen atom or a substituent selected from an alkyl group, an aryl group, a substituted or unsubstituted amino group and a halogen atom.

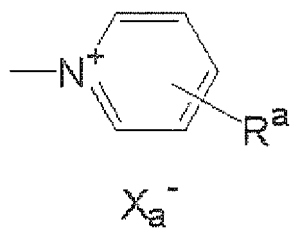

$R^1$ and $R^2$ each independently represents a hydrocarbon group having from 1 to 12 carbon atoms. In view of the preservation stability of a coating solution for image-recording layer, it is preferred that $R^1$ and $R^2$ each represents a hydrocarbon group having two or more carbon atoms. It is particularly preferred that $R^1$ and $R^2$ are combined with each other to form a 5-membered or 6-membered ring.

$Ar^1$ and $Ar^2$, which may be the same or different, each represents an aromatic hydrocarbon group which may have a substituent. Preferred examples of the aromatic hydrocarbon group include a benzene ring group and a naphthalene ring group. Also, preferred examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms, which may have a substituent. Preferred examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not needed. In view of the preservation stability of a coating solution for image-recording layer, preferred examples of the counter ion for $Za^-$ include a halide ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion.

Specific examples of the cyanine dye represented by formula (a), which can be preferably used in the invention, include those described in Paragraph Nos. [0017] to [0019] of JP-A-2001-133969, Paragraph Nos. [0012] to [0021] of JP-A-2002-23360 and Paragraph Nos. [0012] to [0037] of JP-A-2002-40638.

The infrared absorbing agents (A) may be used only one kind or in combination of two or more kinds thereof and it may also be used together with an infrared absorbing agent other than the infrared absorbing dye, for example, a pigment. As the pigment, compounds described in Paragraph Nos. [0072] to [0076] of JP-A-2008-195018 are preferred.

The content of the infrared absorbing agent in the image-recording layer according to the invention is preferably from 0.1 to 10.0% by weight, more preferably from 0.5 to 5.0% by weight, based on the total solid content of the image-recording layer.

(B) Radical polymerization initiator

The radical polymerization initiator (B) for use in the invention indicates a compound which initiates or accelerates polymerization of a radical polymerizable compound (C). The radical polymerization initiator for use in the invention includes, for example, known thermal polymerization initiators, compounds containing a bond having small bond dissociation energy and photopolymerization initiators.

The radical polymerization initiator according to the invention include, for example, (a) an organic halide, (b) a carbonyl compound, (c) an azo compound, (d) an organic peroxide, (e) a metallocene compound, (f) an azide compound, (g) a hexaarylbiimidazole compound, (h) an organic borate compound, (i) a disulfone compound, (j) an oxime ester compound and (k) an onium salt compound.

As the organic halide (a), compounds described in Paragraph Nos. [0022] to [0023] of JP-A-2008-195018 are preferred.

As the carbonyl compound (b), compounds described in Paragraph No. [0024] of JP-A-2008-195018 are preferred.

As the azo compound (c), for example, azo compounds described in JP-A-8-108621 are used.

As the organic peroxide (d), for example, compounds described in Paragraph No. [0025] of JP-A-2008-195018 are preferred.

As the metallocene compound (e), for example, compounds described in Paragraph No. [0026] of JP-A-2008-195018 are preferred.

As the azide compound (f), a compound, for example, 2,6-bis(4-azidobenzylidene)-4-methylcyclohexanone is exemplified.

As the hexaarylbiimidazole compound (g), for example, compounds described in Paragraph No. [0027] of JP-A-2008-195018 are preferred.

As the organic borate compound (h), for example, compounds described in Paragraph No. [0028] of JP-A-2008-195018 are preferred.

As the disulfone compound (i), for example, compounds described in JP-A-61-166544 and JP-A-2002-328465 are exemplified.

As the oxime ester compound (j), for example, compounds described in Paragraph Nos. [0028] to [0030] of JP-A-2008-195018 are preferred.

As the onium salt compound (k), onium salts, for example, diazonium salts described in S. I. Schlesinger, Photogr. Sci. End., 18, 387 (1974) and T. S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848 and JP-A-2008-195018, sulfonium salts described in European Patents 370,693, 390,214, 233,567, 297,443 and 297,442, U.S. Patents 4,933,377, 4,760,013, 4,734,444 and 2, 833, 827 and German Patents 2, 904, 626, 3, 604, 580 and 3,604,581, selenonium salts described in J. V. Crivello et al., Macromolecules, 10 (6), 1307 (1977) and J. V . Crivello et al., J. Polymer Sci., Polymer Chem. Ed., 17, 1047 (1979), arsonium salts described in C. S. Wen et al., Teh, Proc. Conf. Rad. Curing ASIA, p. 478, Tokyo, Oct. (1988), and azinium salts described in JP-A-2008-195018 are exemplified.

Of the radical polymerization initiators described above, the onium salt, in particular, the iodonium salt, the sulfonium salt or the azinium salt is more preferred. Specific examples of these compounds are set forth below, but the invention should not be construed as being limited thereto.

Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate and tris(4-chlorophenyl)sulfonium 3,5-bis(methoxycarbonyl)benzenesulfonate.

Examples of the azinium salt include 1-cyclohexylmethyloxypyridinium hexafluorophosphate, 1-cyclohexyloxy-4-phenylpyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

The radical polymerization initiator can be added preferably in an amount from 0.1 to 50% by weight, more preferably from 0.5 to 30% by weight, particularly preferably from 0.8 to 20% by weight, based on the total solid content constituting the image-recording layer. In the range described above, good sensitivity and good stain resistance in the non-image area at the time of printing are obtained.

(C) Radical polymerizable compound

The radical polymerizable compound (C) for use in the invention is an addition-polymerizable compound having at least one ethylenically unsaturated double bond, and it is preferably selected from compounds having at least one, preferably two or more, terminal ethylenically unsaturated double bonds. Such compounds are widely known in the field of art and they can be used in the invention without any particular limitation. The compound has a chemical form, for example, a monomer, a prepolymer, specifically, a dimer, a trimer or an oligomer, or a mixture thereof, or a (co)polymer thereof.

Specific examples of the radical polymerizable compound include compounds described in Paragraph Nos. [0089] to [0098] of JP-A-2008-195018. Among them, esters of aliphatic polyhydric alcohol compound with an unsaturated carboxylic acid (for example, acrylic acid, methacrylic acid, itaconic acid, crotonic acid, isocrotonic acid or maleic acid) are preferably exemplified. Other preferred radical polymerizable compounds include polymerizable compounds containing an isocyanuric acid structure described in JP-A-2005-329708.

Of the compounds described above, isocyanuric acid ethylene oxide-modified acrylates, for example, tris(acryloyloxyethyl) isocyanurate or bis(acryloyloxyethyl)hydroxyethyl isocyanurate are particularly preferred, because they are

excellent in balance between hydrophilicity relating to the on-press development property and polymerization ability relating to the printing durability.

In the invention, the radical polymerizable compound (C) is preferably used in an amount from 5 to 80% by weight, more preferably from 15 to 75% by weight, based on the total solid content of the image-recording layer.

(D) Binder polymer

In the image-recording layer according to the invention, a binder polymer can be used for the purpose of improving film strength of the image-recording layer. The binder polymer which can be used in the invention can be selected from those heretofore known without restriction, and polymers having a film-forming property are preferred. Among them, an acrylic resin, a polyvinyl acetal resin or a polyurethane resin is preferred.

As the binder polymer preferred for the invention, a polymer having a crosslinkable functional group for improving film strength of the image area in its main chain or side chain, preferably in its side chain, as described in JP-A-2008-195018 is exemplified. Due to the crosslinkable functional group, crosslinkage is formed between the polymer molecules to facilitate curing.

As the crosslinkable functional group, an ethylenically unsaturated group, for example, a (meth)acryl group, a vinyl group or an allyl group or an epoxy group is preferred. The crosslinkable functional group can be introduced into the polymer by a polymer reaction or copolymerization. For instance, a reaction between an acrylic polymer or polyurethane having a carboxyl group in its side chain and glycidyl methacrylate or a reaction between a polymer having an epoxy group and a carboxylic acid containing an ethylenically unsaturated group, for example, methacrylic acid can be utilized.

The content of the crosslinkable group in the binder polymer is preferably from 0.1 to 10.0 mmol, more preferably from 1.0 to 7.0 mmol, most preferably from 2.0 to 5.5 mmol, based on 1 g of the binder polymer.

It is also preferred that the binder polymer for use in the invention further contains a hydrophilic group. The hydrophilic group contributes to impart the on-press development property to the image-recording layer. In particular, coexistence of the crosslinkable group and the hydrophilic group makes it possible to maintain compatibility between the printing durability and development property.

The hydrophilic group includes, for example, a hydroxy group, a carboxyl group, an alkylene oxide structure, an amino group, an ammonium group, an amido group, a sulfo group and a phosphoric acid group. Among them, an alkylene oxide structure containing from 1 to 9 alkylene oxide units having 2 or 3 carbon atoms is preferred. In particular, a polyethylene oxide structure containing from 2 to 8 ethylene oxide units is preferred. This improves ink receptivity. In order to introduce a hydrophilic group into the binder polymer, a monomer having the hydrophilic group is copolymerized.

In order to control the ink receptivity, an oleophilic group, for example, an alkyl group, an aryl group, an aralkyl group or an alkenyl group may be introduced into the binder polymer according to the invention. Specifically, an oleophilic group-containing monomer, for example, an alkyl methacrylate is copolymerized.

Specific examples (1) to (11) of the binder polymer for use in the invention are set forth below, but the invention should not be construed as being limited thereto. The ratio of the repeating units is indicated as a molar ratio.

(1) 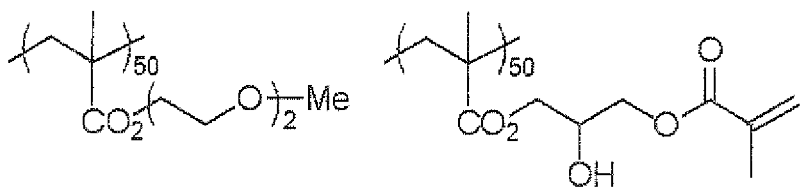

(2) 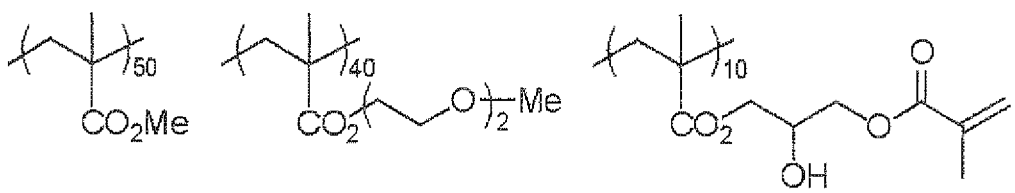

(3) 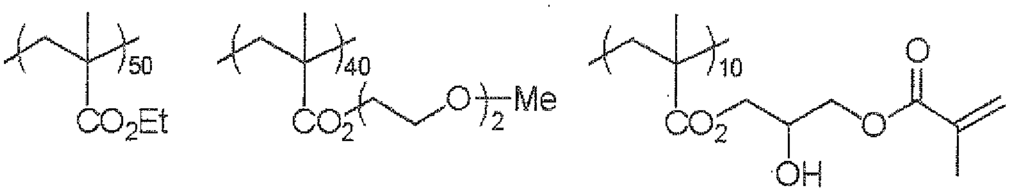

(4) 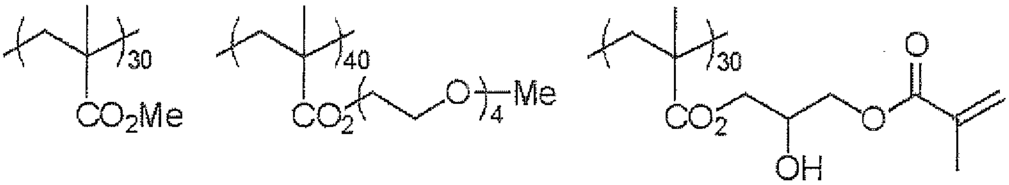

(5) 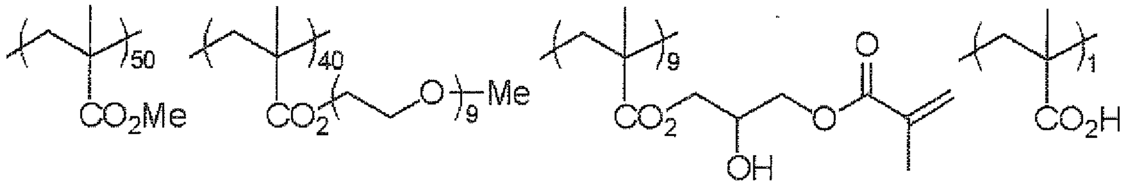

(6) 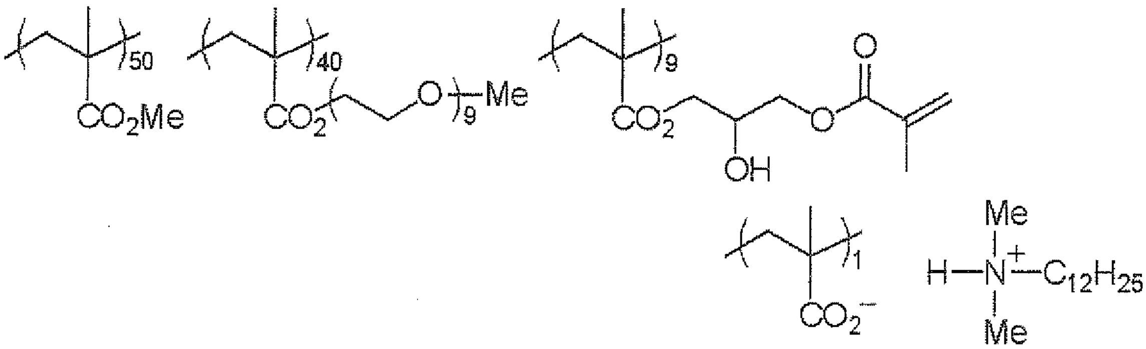

(7) 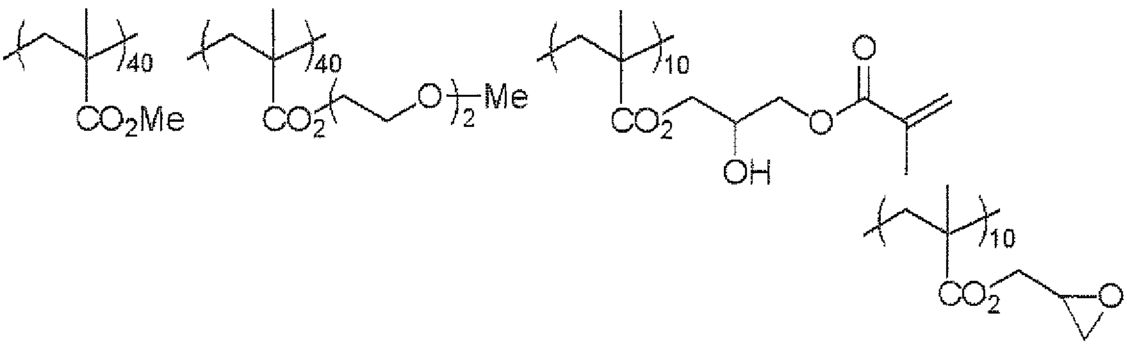

(8) 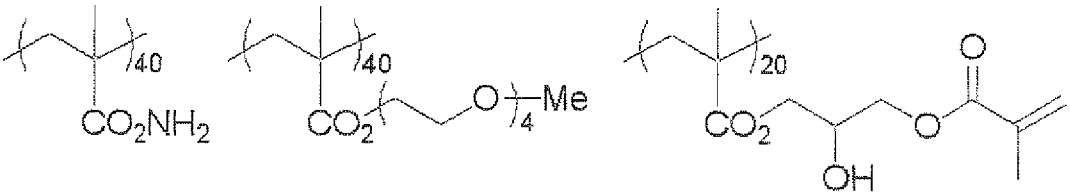

(9) 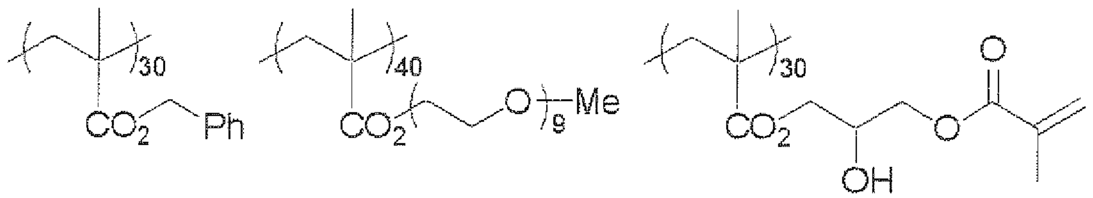

(10) 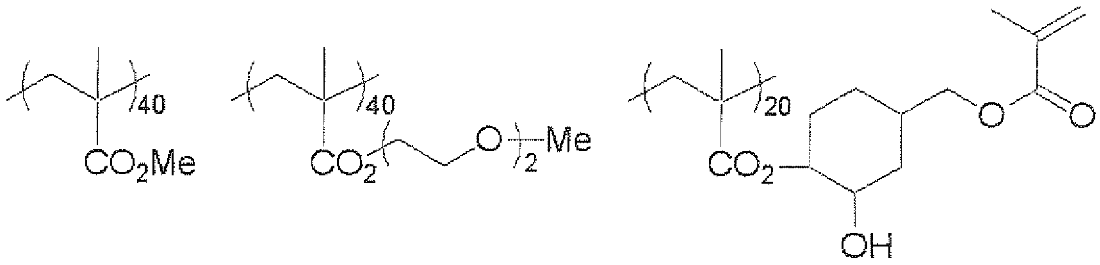

(11) 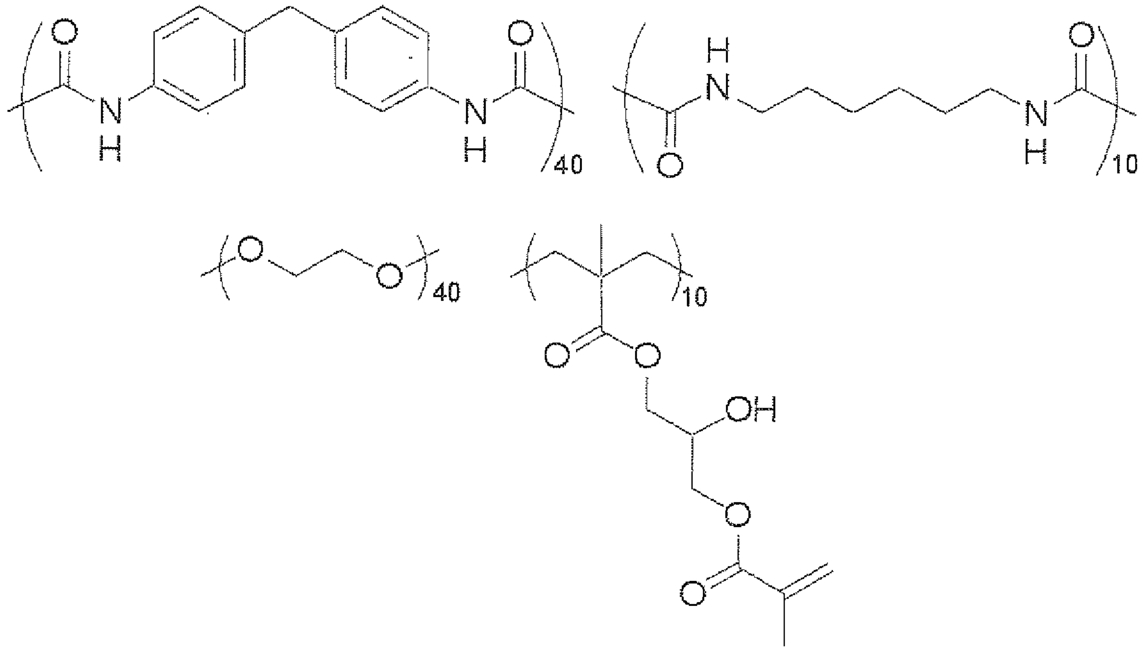

The weight average molecular weight (Mw) of the binder polymer according to the invention is preferably 2, 000 or more, more preferably 5,000 or more, and still more preferably from 10,000 to 300,000.
According to the invention, a hydrophilic polymer, for example, polyacrylic acid or polyvinyl alcohol described in JP-A-2008-195018 may be used, if desired. Further, an oleophilic binder polymer is used together with a hydrophilic binder polymer.
The content of the binder polymer is ordinarily from 5 to 90% by weight, preferably from 5 to 80% by weight, more preferably from 10 to 70% by weight, based on the total solid content of the image-recording layer.

(E) Polymer fine particle

According to the invention, a polymer fine particle can be used in order to improve the on-press development property. In particular, a polymer fine particle having a polyalkylene oxide structure is preferred. A polymer fine particle having a polyalkylene oxide group in its side chain is particularly preferred. This increases permeability of dampening water to improve the on-press development property.
As the polyalkylene oxide structure, an alkylene oxide structure containing from 2 to 120 alkylene oxide units having from 2 to 3 carbon atoms is preferred, and a polyethylene oxide structure containing from 2 to 120 ethylene oxide units is more preferred. Particularly, a polyethylene oxide structure containing from 20 to 100 ethylene oxide units is preferred. By means of such a polymer fine particle containing a polyalkylene oxide structure, compatibility between the

printing durability and on-press development property can be achieved. Also, the ink receptivity can be improved.

The polymer fine particle according to the invention is preferably a hydrophobilizing precursor capable of converting the image-recording layer to be hydrophobic when heat is applied. The hydrophobilizing precursor polymer fine particle is preferably at least one fine particle selected from a hydrophobic thermoplastic polymer fine particle, a thermo-reactive polymer fine particle, a microcapsule having a hydrophobic compound encapsulated and a microgel (crosslinked polymer fine particle). Among them, a polymer fine particle having a polymerizable group and a microgel are preferred. In order to improve the on-press development property, the polymer fine particle preferably contains a polyalkylene oxide structure as described above.

As the hydrophobic thermoplastic polymer fine particle, hydrophobic thermoplastic polymer fine particles described, for example, in Research Disclosure, No. 333003, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile or polymethyl methacrylate is more preferred.

The average particle size of the hydrophobic thermoplastic polymer fine particle for use in the invention is preferably from 0.01 to 2.0 μm.

The thermo-reactive polymer fine particle for use in the invention includes a polymer fine particle having a thermo-reactive group and forms a hydrophobilized region by crosslinkage due to thermal reaction and change in the functional group involved therein.

As the thermo-reactive group of the polymer fine particle having a thermo-reactive group for use in the invention, a functional group performing any reaction can be used as long as a chemical bond is formed. For instance, an ethylenically unsaturated group (for example, an acryloyl group, a methacryloyl group, a vinyl group or an allyl group) performing a radical polymerization reaction, a cationic polymerizable group (for example, a vinyl group or a vinyloxy group), an isocyanate group or a blocked form thereof, an epoxy group or a vinyloxy group performing an addition reaction and a functional group having an active hydrogen atom (for example, an amino group, a hydroxy group or a carboxyl group) as the reaction partner thereof, a carboxyl group performing a condensation reaction and a hydroxy group or an amino group as the reaction partner thereof, and an acid anhydride performing a ring opening addition reaction and an amino group or a hydroxy group as the reaction partner thereof are preferably exemplified.

As the microcapsule for use in the invention, microcapsule having all or part of the constituting components of the image-recording layer encapsulated as described, for example, in JP-A-2001-277740 and JP-A-2001-277742 is exemplified. The constituting components of the image-recording layer may be present outside the microcapsule. It is a preferred embodiment of the image-recording layer containing microcapsule that hydrophobic constituting components are encapsulated in the microcapsule and hydrophilic constituting components are present outside the microcapsule.

The image-recording layer according to the invention may be an embodiment containing a crosslinked resin particle, that is, a microgel. The microgel can contain a part of the constituting components of the image-recording layer inside and/or on the surface thereof. Particularly, an embodiment of a reactive microgel containing the radical polymerizable compound (C) on the surface thereof is preferred in view of the image-forming sensitivity and printing durability.

As a method of microencapsulation or microgelation of the constituting components of the image-recording layer, known methods can be used.

The average particle size of the microcapsule or microgel is preferably from 0.01 to 3.0 μm, more preferably from 0.05 to 2.0 μm, particularly preferably from 0.10 to 1.0 μm. In the range described above, good resolution and good time-lapse stability can be achieved.

The content of the polymer fine particle is preferably in a range from 5 to 90% by weight based on the total solid content of the image-recording layer.

(F) Other components

The image-recording layer according to the invention may further contain other components, if desired.

(1) Hydrophilic low molecular weight compound

The image-recording layer according to the invention may contain a hydrophilic low molecular weight compound in order to improve the on-press development property without accompanying the decrease in the printing durability.

The hydrophilic low molecular weight compound includes a water-soluble organic compound, for example, a glycol, e.g., ethylene glycol, diethylene glycol, triethylene glycol, propylene glycol, dipropylene glycol or tripropylene glycol, or an ether or ester derivative thereof, a polyhydroxy compound, e.g., glycerine, pentaerythritol or tris(2-hydroxyethyl) isocyanurate, an organic amine, e.g., triethanol amine, diethanol amine monoethanol amine, or a salt thereof, an organic sulfonic acid, e.g., an alkyl sulfonic acid, toluene sulfonic acid or benzene sulfonic acid, or a salt thereof, an organic sulfamic acid, e.g., an alkyl sulfamic acid, or a salt thereof, an organic sulfuric acid, e.g., an alkyl sulfuric acid or an alkyl ether sulfuric acid, or a salt thereof, an organic phosphonic acid, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine.

According to the invention, it is preferred that at least one compound selected from a polyol, an organic sulfate, an organic sulfonate and a betaine is incorporated.

Specific examples of the organic sulfonate include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate; and an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1, 5-naphtyldisulfonate or trisodium 1,3, 6-naphtyltrisulfonate. The salt may also be a potassium salt or a lithium salt.

The organic sulfate includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt.

As the betaine, a compound wherein a number of carbon atoms included in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptivity and printing durability of the image-recording layer can be preferably maintained.

The amount of the hydrophilic low molecular weight compound added to the image-recording layer is preferably from 0.5 to 20% by weight, more preferably from 1 to 10% by weight, still more preferably from 2 to 8% by weight, based on the total solid content of the image-recording layer. In the range described above, good on-press development property and good printing durability are achieved.

The hydrophilic low molecular weight compounds may be used individually or as a mixture of two or more thereof.

(2) Oil-sensitizing agent

In order to improve the ink receptivity, an oil-sensitizing agent, for example, a phosphonium compound, a nitrogen-containing low molecular weight compound or an ammonium group-containing polymer can be used in the image-recording layer. In particular, in the case where an inorganic stratiform compound is incorporated into an overcoat layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate and benzyldimethyldodecylammonium hexafluorophosphate.

The ammonium group-containing polymer may be any polymer containing an ammonium group in its structure and is preferably a polymer containing from 5 to 80% by mole of (meth) acrylate having an ammonium group in its side chain as a copolymerization component.

As to the ammonium salt-containing polymer, its reduced specific viscosity value (unit: cSt/g/ml) determined according to the measuring method described below is preferably from 5 to 120, more preferably from 10 to 110,

particularly preferably from 15 to 100.

<Measuring method of reduced specific viscosity>

In a 20 ml measuring flask was weighed 3.33 g of a 30% polymer solution (1 g as a solid content) and the measuring flask was filled up to the gauge line with N-methyl pyrrolidone. The resulting solution was put into an Ubbelohde viscometer (viscometer constant: 0.010 cSt/s) and a period for running down of the solution at 30°C was measured. The viscosity was determined in a conventional manner according to the following calculating formula:

Kinetic viscosity = Viscometer constant x Period for liquid to pass through a capillary (sec)

Specific examples of the ammonium group-containing polymer are set forth below.

(1) 2-(Trimethylammonio)ethyl methacrylate p-toluenesulfonate/3,6-dioxaheptyl methacrylate copolymer (molar ratio: 10/90)
(2) 2-(Trimethylammonio)ethyl methacrylate hexafluorophosphate /3,6-dioxaheptyl methacrylate copolymer (molar ratio: 20/80)
(3) 2-(Ethyldimethylammonio)ethyl methacrylate p-toluenesulfonate/hexyl methacrylate copolymer (molar ratio: 30/70)
(4) 2-(Trimethylammonio)ethyl methacrylate hexafluorophosphate /2-ethylhexyl methacrylate copolymer (molar ratio: 20/80)
(5) 2-(Trimethylammonio)ethyl methacrylate methylsulfate/hexyl methacrylate copolymer (molar ratio: 40/60)
(6) 2-(Butyldimethylammonio)ethyl methacrylate hexafluorophosphate/3,6-dioxaheptyl methacrylate copolymer (molar ratio: 20/80)
(7) 2-(Butyldimethylammonio)ethyl acrylate hexafluorophosphate/3,6-dioxaheptyl methacrylate copolymer (molar ratio: 20/80)
(8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80)
(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5)

The content of the oil-sensitizing agent is preferably from 0.01 to 30.0% by weight, more preferably from 0.1 to 15.0% by weight, still more preferably from 1 to 5% by weight, based on the total solid content of the image-recording layer.

(3) Other components

Other components, for example, a surfactant, a coloring agent, a print-out agent, a polymerization inhibitor, a higher fatty acid derivative, a plasticizer, a fine inorganic particle, an inorganic stratiform compound, a co-sensitizer or a chain transfer agent may further be added to the image-recording layer. Specifically, compounds and amounts added thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

(G) Formation of image-recording layer

The image-recording layer according to the invention is formed by dispersing or dissolving each of the necessary constituting components described above in a known solvent to prepare a coating solution and coating the solution on a support by a known method, for example, bar coater coating and drying as described in Paragraph Nos. [0142] to [0143] of JP-A-2008-195018. The coating amount (solid content) of the image-recording layer formed on the support after coating and drying may be varied according to the intended purpose but is in general preferably from 0.3 to 3.0 g/m$^2$. In the range described above, good sensitivity and good film property of the image-recording layer can be achieved.

(Undercoat layer)

In the lithographic printing plate precursor according to the invention, an undercoat layer (also referred to as

an intermediate layer) is preferably provided between the image-recording layer and the support. The undercoat layer strengthens adhesion between the support and the image-recording layer in the exposed area and makes removal of the image-recording layer from the support in the unexposed area easy, thereby contributing improvement in the development property without accompanying degradation of the printing durability. Further, it is advantageous that in the case of infrared laser exposure, since the undercoat layer acts as a heat insulating layer, decrease in sensitivity due to diffusion of heat generated upon the exposure into the support is prevented.

As a compound for use in the undercoat layer, specifically, for example, a silane coupling agent having an addition-polymerizable ethylenic double bond reactive group described in JP-A-10-282679 and a phosphorus compound having an ethylenic double bond reactive group described in JP-A-2-304441 are preferably exemplified. A polymer resin having an adsorbing group capable of adsorbing to a surface of the support, a hydrophilic group and a crosslinkable group as described in JP-A-2005-125749 and JP-A-2006-188038 is more preferably exemplified. The polymer resin is preferably a copolymer of a monomer having an adsorbing group, a monomer having a hydrophilic group and a monomer having a crosslinkable group. More specifically, a polymer resin which is a copolymer of a monomer having an adsorbing group, for example, a phenolic hydroxy group, a carboxyl group, $-PO_3H_2$, $-OPO_3H_2$, $-CONHSO_2-$, $-SO_2NHSO_2-$ and $-COCH_2COCH_3$, a monomer having a hydrophilic sulfo group and a monomer having a polymerizable crosslinkable group, for example, a methacryl group or an allyl group. The polymer resin may contain a crosslinkable group introduced by a salt formation between a polar substituent of the polymer resin and a compound containing a substituent having a counter charge to the polar substituent of the polymer resin and an ethylenically unsaturated bond and also may be further copolymerized with a monomer other than those described above, preferably a hydrophilic monomer.

The content of the unsaturated double bond in the polymer resin for undercoat layer is preferably from 0.1 to 10.0 mmol, most preferably from 2.0 to 5.5 mmol, based on 1 g of the polymer resin.

The weight average molecular weight of the polymer resin for undercoat layer is preferably 5, 000 or more, more preferably from 10, 000 to 300,000.

The undercoat layer according to the invention may contain a chelating agent, a secondary or tertiary amine, a polymerization inhibitor or a compound containing an amino group or a functional group having polymerization inhibition ability and a group capable of interacting with the surface of aluminum support (for example, 1,4-diazobicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid) in addition to the compounds for the undercoat layer described above in order to prevent the occurrence of stain due to the lapse of time.

The undercoat layer is coated according to a known method. The coating amount (solid content) of the undercoat layer is preferably from 0.1 to 100 mg/m$^2$, and more preferably from 1 to 30 mg/m$^2$.

(Support)

As the support for use in the lithographic printing plate precursor according to the invention, a known support is used. Particularly, an aluminum plate subjected to roughening treatment and anodizing treatment according to a known method is preferred.

Also, other treatments, for example, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has a center line average roughness of 0.10 to 1.2 $\mu$m.

The support may have a backcoat layer containing an organic polymer compound described in JP-A-5-45885 or an alkoxy compound of silicon described in JP-A-6-35174, provided on the back surface thereof, if desired.

[Plate making method]

Plate making of the lithographic printing plate precursor according to the invention is preferably performed by an on-press development method. The on-press development method includes a step in which the lithographic printing plate precursor is imagewise exposed and a printing step in which oily ink and an aqueous component are supplied to the exposed lithographic printing plate precursor without undergoing any development processing to perform printing, and it is characterized in that the unexposed area of the lithographic printing plate precursor is removed in the course of the printing step. The imagewise exposure may be performed on a printing machine after the lithographic printing plate precursor is mounted on the printing machine or may be separately performed using a platesetter or the like. In the latter case, the exposed lithographic printing plate precursor is mounted as it is on a printing machine without undergoing a development processing step. Then, the printing operation is initiated using the printing machine with supplying oily ink and an aqueous component and at an early stage of the printing the on-press development is carried

out. Specifically, the image-recording layer in the unexposed area is removed and the hydrophilic surface of support is revealed therewith to form the non-image area. As the oily ink and aqueous component, printing ink and dampening water for conventional lithographic printing can be employed, respectively.

The on-press development method is described in more detail below.

As the light source used for the image exposure in the invention, a laser is preferred. The laser for use in the invention is not particularly restricted and includes, for example, a solid laser or semiconductor laser emitting an infrared ray having a wavelength of 760 to 1,200 nm.

With respect to the infrared ray laser, the output is preferably 100 mW or more, the exposure time per pixel is preferably within 20 microseconds, and the irradiation energy is preferably from 10 to 300 mJ/$cm^2$. With respect to the laser exposure, in order to shorten the exposure time, it is preferred to use a multibeam laser device.

The exposed lithographic printing plate precursor is mounted on a plate cylinder of a printing machine. In case of using a printing machine equipped with a laser exposure apparatus, the lithographic printing plate precursor is mounted on a plate cylinder of the printing machine and then subjected to the imagewise exposure.

When dampening water and printing ink are supplied to the imagewise exposed lithographic printing plate precursor to perform printing, in the exposed area of the image-recording layer, the image-recording layer cured by the exposure forms the printing ink receptive area having the oleophilic surface. On the other hand, in the unexposed area, the uncured image-recording layer is removed by dissolution or dispersion with the dampening water and/or printing ink supplied to reveal the hydrophilic surface in the area. As a result, the dampening water adheres on the revealed hydrophilic surface and the printing ink adheres to the exposed area of the image-recording layer, whereby printing is initiated.

While either the dampening water or printing ink may be supplied at first on the surface of lithographic printing plate precursor, it is preferred to supply the dampening water at first from the standpoint that the permeation of dampening water into the uncured image-recording layer is not inhibited by the printing ink.

Thus, the lithographic printing plate precursor according to the invention is subjected to the on-press development on an offset printing machine and used as it is for printing a large number of sheets.

## EXAMPLE

The present invention will be described in more detail with reference to the following examples, but the invention should not be construed as being limited thereto. A molecular weight of the polymer compound means a weight average molecular weight and a ratio of repeating unit is indicated in mole percent.

<u>Examples 1 to 60 and Comparative Examples 1 to 75</u>

1. Preparation of Lithographic printing plate precursors (1) to (45)

(1) Preparation of Support

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/$cm^3$) of pumice having a median size of 25 μm, followed by thorough washing with water. The plate was subjected to etching by immersing in a 25% by weight aqueous sodiumhydroxide solution of 45°C for 9 seconds, washed with water, then immersed in a 20% by weight nitric acid solution at 60°C for 20 seconds, and washed with water. The etching amount of the grained surface was about 3 g/$m^2$.

Then, using an alternating current of 60 Hz, an electrochemical roughening treatment was continuously carried out on the plate. The electrolytic solution used was a 1% by weight aqueous nitric acid solution (containing 0. 5% by weight of aluminum ion) and the temperature of electrolytic solution was 50°C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/$dm^2$ in terms of the peak value of the electric current, and 5% of the electric current flowing from the electric source was divided to the auxiliary anode. The quantity of electricity in the nitric acid electrolysis was 175 C/$dm^2$ in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing

0.5% by weight of aluminum ion) having temperature of 50°C and under the condition that the quantity of electricity was 50 C/dm$^2$ in terms of the quantity of electricity when the aluminum plate functioned as an anode. The plate was then washed with water by spraying.

The plate was then subjected to an anodizing treatment using as an electrolytic solution, a 15% by weight sulfuric acid solution (containing 0.5% by weight of aluminum ion) at a current density of 15 A/dm$^2$ to form a direct current anodized film of 2.5 g/m$^2$, washed with water and dried to prepare Support (1).

Thereafter, in order to ensure the hydrophilicity of the non-image area, Support (1) was subjected to silicate treatment using a 2.5% by weight aqueous sodium silicate No. 3 solution at 60°C for 10 seconds and then was washed with water to obtain Support (2). The adhesion amount of Si was 10 mg/m$^2$. The center line average roughness (Ra) of the support was measured using a stylus having a diameter of 2 μm and found to be 0.51 μm.

(2) Formation of Undercoat layer

Coating solution (1) for undercoat layer shown below was coated on Support (2) described above so as to have a dry coating amount of 20 mg/m$^2$ to prepare a support having an undercoat layer for using in the experiments described below.

<Coating solution (1) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

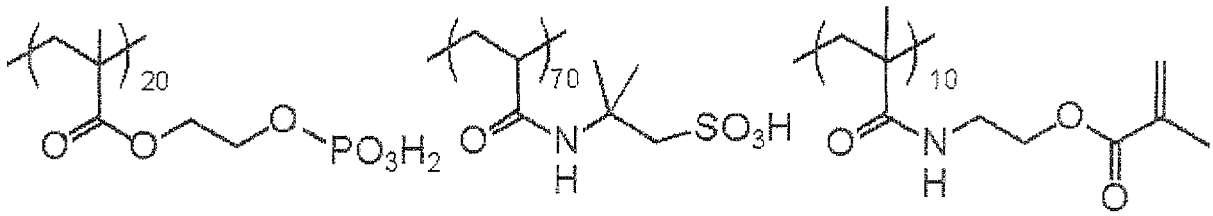

(Mw: 100,000)

Compound (1) for undercoat layer

(3) Formation of Image-recording layer

Coating solution (1) for image-recording layer having the composition shown below was coated on the undercoat layer described above by a bar and dried in an oven at 100°C for 60 seconds to form an image-recording layer having a dry coating amount of 1.0 g/m$^2$.

Coating solution (1) for image-recording layer was prepared by mixing Photosensitive solution (1) shown below with Microgel solution (1) shown below just before the coating, followed by stirring.

<Photosensitive solution (1)>

| | |
|---|---|
| Binder polymer (1) having structure shown below | 0.240 g |
| Infrared absorbing dye (1) having structure shown below | 0.030 g |
| Radical polymerization initiator (1) having structure shown below | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |

(continued)

| | |
|---|---|
| Hydrophilic low molecular weight compound (1) having structure shown below | 0.050 g |
| Oil-sensitizing agent (Phosphonium compound (1) having structure shown below) | 0.055 g |
| Oil-sensitizing agent (Benzyl dimethyl octyl ammonium $PF_6$ salt | 0.018 g |
| Oil-sensitizing agent (Ammonium group-containing polymer having structure shown below (reduced specific viscosity: 44 cSt/g/ml) | 0.035 g |
| Fluorine-based surfactant (1) having structure shown below | 0.008 g |
| 2-Butanone | 1.091 g |
| 1-Methoxy-2-propanol | 8.609 g |

<Microgel solution (1)>

| | |
|---|---|
| Microgel (1) shown below | 2.640 g |
| Distilled water | 2.425 g |

The structures of Binder polymer (1), Infrared absorbing dye (1), Radical polymerization initiator (1), Phosphonium compound (1), Hydrophilic low molecular weight compound (1), Ammonium group-containing polymer and Fluorine-based surfactant (1) are shown below.

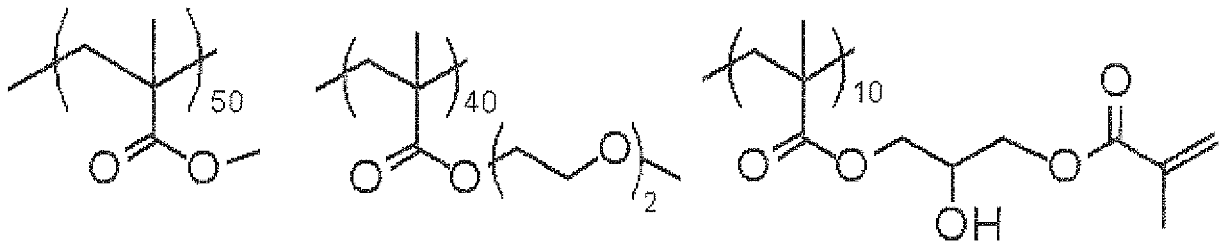

(Mw: 70,000)

Binder polymer (1)

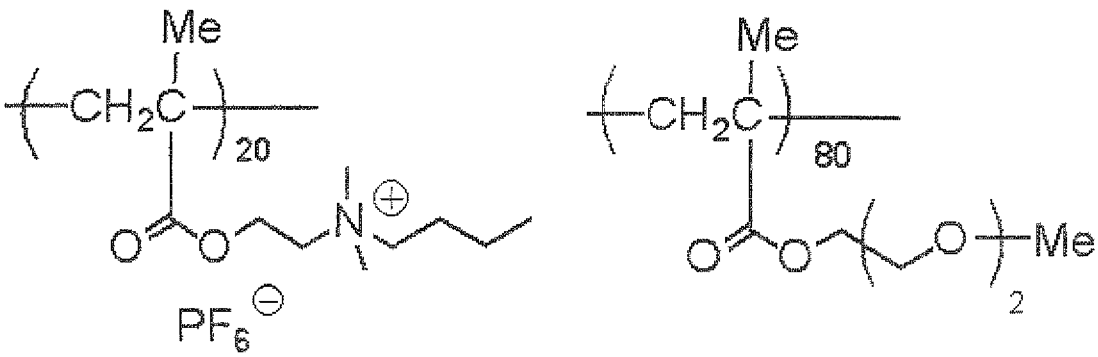

Ammonium group-containing polymer

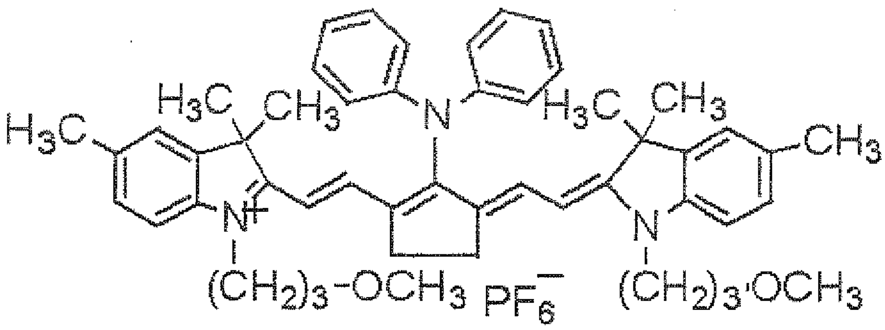

Infrared absorbing dye (1)

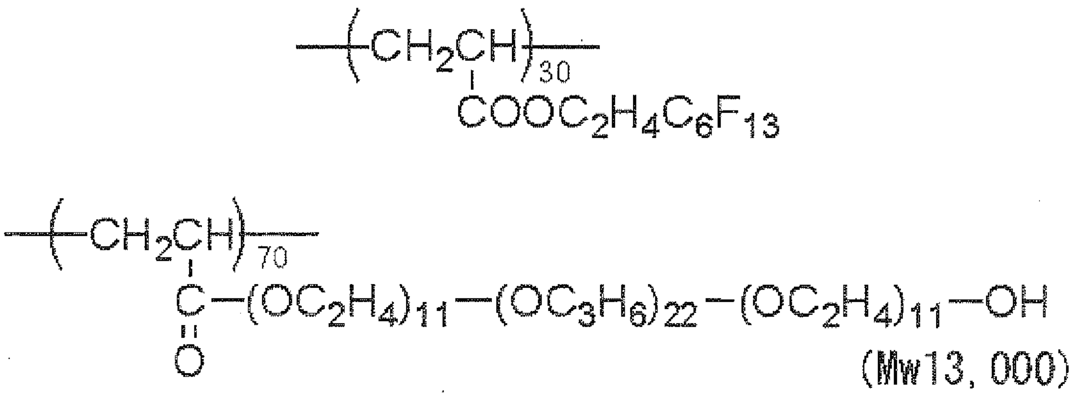

Fluorine-based surfactant (1)

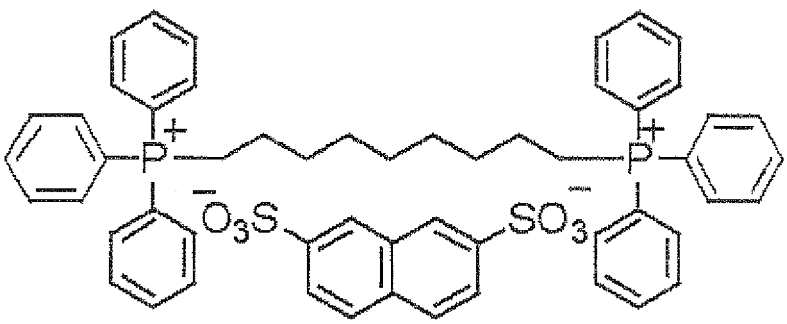

Phosphonium compound (1)

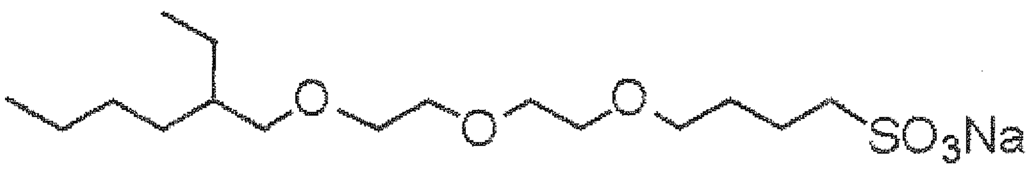

Hydrophilic low molecular weight compound (1)

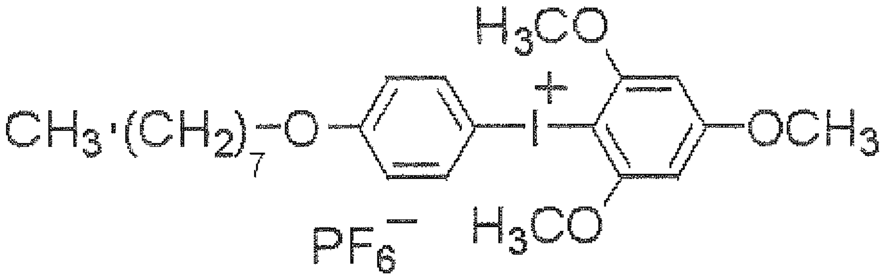

Radical polymerization initiator (1)

<Preparation of Microgel (1)>

An oil phase component was prepared by dissolving 4.46 g of polyfunctional isocyanate having the structure shown below (produced by Mitsui Chemicals Polyurethane, Inc., 75% ethyl acetate solution), 0.86 g of adduct obtained by addition of trimethylolpropane (6 mol) and xylene diisocyanate (18 mol) and further addition of methyl-terminated polyoxyethylene (1 mol) (number of oxyethylene repeating unit: 90) (produced by Mitsui Chemicals Polyurethane, Inc., 50% ethyl acetate solution), 1.72 g of pentaerythritol tetraacrylate (SR399E, produced by Sartomer Co.) and 0.05 g of PIONIN A-41C (produced by Takemoto Oil & Fat Co., Ltd., 70% methanol solution) in 4.46 g of ethyl acetate. The oil phase component and 17.30 g of water as an aqueous phase component were mixed and emulsified using a homogenizer at 10,000 rpm for 15 minutes. The resulting emulsion was stirred at 40°C for 4 hours. The microgel liquid thus-obtained was diluted using water so as to have the solid content concentration of 21.8% by weight. The average particle size of the microgel was 0.25 μm.

Polyfunctional isocyanate

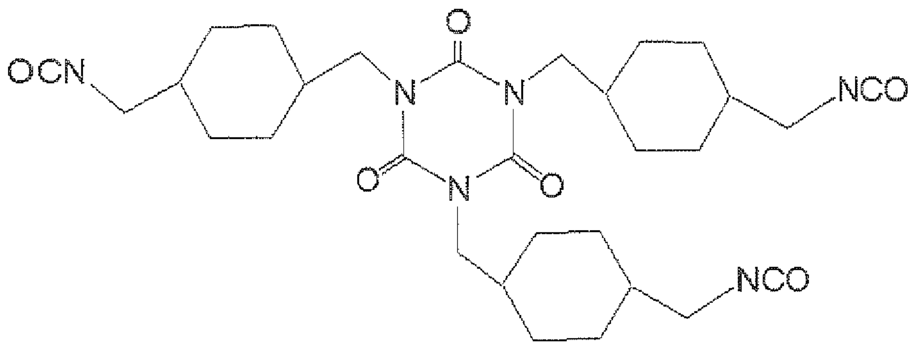

(3) Formation of Overcoat layer

Coating solution (1) for overcoat layer having the composition shown below was further coated on the image-recording layer described above by a bar and dried in an oven at 120°C for 60 seconds to form an overcoat layer having a dry coating amount of 0.15 g/$m^2$, thereby preparing Lithographic printing plate precursors (1) to (45) for Examples 1 to 20 and Comparative Examples 1 to 25, respectively.

<Coating solution (1) for overcoat layer>

| | |
|---|---|
| Dispersion (1) of inorganic stratiform compound shown below | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.30 g |
| Aqueous 1% by weight solution of surfactant (EMALEX 710, produced by Nihon Emulsion Co., Ltd.) | 0.86 g |
| Ion-exchanged water | 6.0 g |

<Preparation of Dispersion (1) of inorganic stratiform compound>

To 193.6 g of ion-exchanged water was added an inorganic stratiform compound shown in Table 1 in an amount shown in Table 1 and the mixture was dispersed using a homogenizer until an average particle size (according to a laser scattering method) became 3 μm.

2. Preparation of Lithographic printing plate precursors (46) to (90)

Coating solution (2) for image-recording layer shown below was coated on the support having the undercoat layer described above by a bar and dried in an oven at 70°C for 60 seconds to form an image-recording layer having a dry coating amount of 0.6 g/m$^2$.

<Coating solution (2) for image-recording layer>

| | |
|---|---|
| Aqueous dispersion (1) of polymer fine particle | 20.0 g |
| Infrared absorbing dye (2) having structure shown below | 0.2 g |
| Radical polymerization initiator (IRGACURE 250, produced by Ciba Specialty Chemicals, Inc.) | 0.5 g |
| Radical polymerizable compound (SR-399, produced by Sartomer Co.) | 1.50 g |
| Mercapto-3-triazole | 0.2 g |
| BYK 336 (produced by BYK-Chimie GmbH) | 0.4 g |
| KLUCEL M (produced by Hercules Chemical Co., Inc.) | 4.8 g |
| ELVACITE 4026 (produced by Ineos Acrylica Inc.) | 2.5 g |
| n-Propanol | 55.0 g |
| 2-Butanone | 17.0 g |

The compounds indicated using their trade names in the composition above are shown below.
IRGACURE 250: (4-Methoxyphenyl)[4-(2-methylpropyl)phenyl]iodonium hexafluorophosphate (75% by weight propylene carbonate solution) SR-399: Dipentaerythritol pentaacrylate
BYK 336: Modified dimethylpolysiloxane copolymer (25% by weight xylene/methoxypropyl acetate solution)
KLUCEL M: Hydroxypropyl cellulose (2% by weight aqueous solution) ELVACITE 4026: Highly branched polymethyl methacrylate (10% by weight 2-butanone solution)

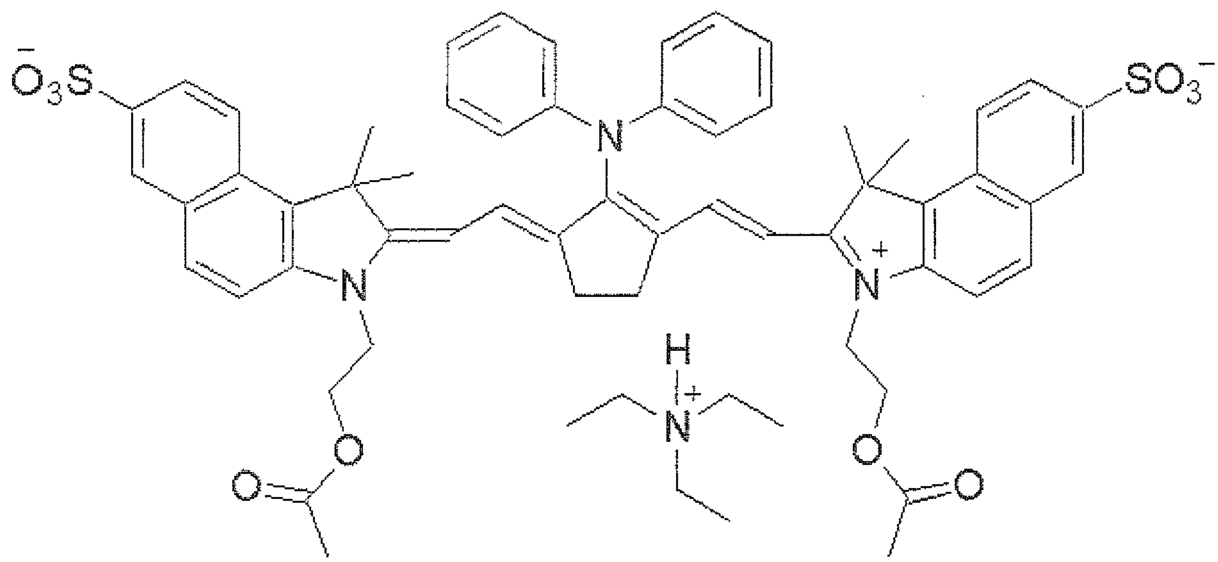

Infrared absorbing dye (2)

(Preparation of Aqueous dispersion (1) of polymer fine particle)

A stirrer, a thermometer, a dropping funnel, a nitrogen inlet tube and a reflux condenser were attached to a 1,000 ml four-neck flask and while carrying out deoxygenation by introduction of nitrogen gas, 10 g of polyethylene glycol methyl ether methacrylate (PEGMA, average repeating unit number of ethylene glycol: 50), 200 g of distilled water and 200 g of n-propanol were charged therein and heated until the internal temperature reached 70°C. Then, a mixture of 10 g of styrene (St), 80 g of acrylonitrile (AN) and 0.8 g of 2, 2' -azobisisobutyronitrile previously prepared was dropwise added to the flask over a period of one hour. After the completion of the dropwise addition, the mixture was continued to react as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion (1) of polymer fine particle of PEGMA/St/AN (10/10/80 in a weight ratio). The particle size distribution of the polymer fine particle had the maximum value at the particle size of 150 nm.

The particle size distribution was determined by taking an electron microphotograph of the polymer fine particle, measuring particle sizes of 5, 000 fine particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

Coating solution (1) for overcoat layer having the composition shown above was further coated on the image-recording layer described above by a bar and dried in an oven at 120°C for 60 seconds to form an overcoat layer having a dry coating amount of 0.15 g/$m^2$, thereby preparing Lithographic printing plate precursors (46) to (90) for Examples 21 to 40 and Comparative Examples 26 to 50, respectively.

3. Preparation of Lithographic printing plate precursors (91) to (135)

Coating solution (3) for image-recording layer shown below was coated on the support having the undercoat layer described above by a bar and dried in an oven at 70°C for 60 seconds to form an image-recording layer having a dry coating amount of 0.6 g/$m^2$.

<Coating solution (3) for image-recording layer>

| | |
|---|---|
| Aqueous dispersion (2) of polymer fine particle | 33.0 g |
| Infrared absorbing dye (3) having structure shown below | 1.0 g |
| Radical polymerization initiator (2) | 4.0 g |
| NK ESTER BPE-1300 having structure shown below (produced by Shin-Nakamura Chemical Co., Ltd.) | 4.5 g |
| Polyacrylic acid (weight average molecular weight: 20,000) | 0.4 g |
| Disodium 1,5-naphthalenedisulfonate | 0.1 g |
| Methanol | 16.0 g |

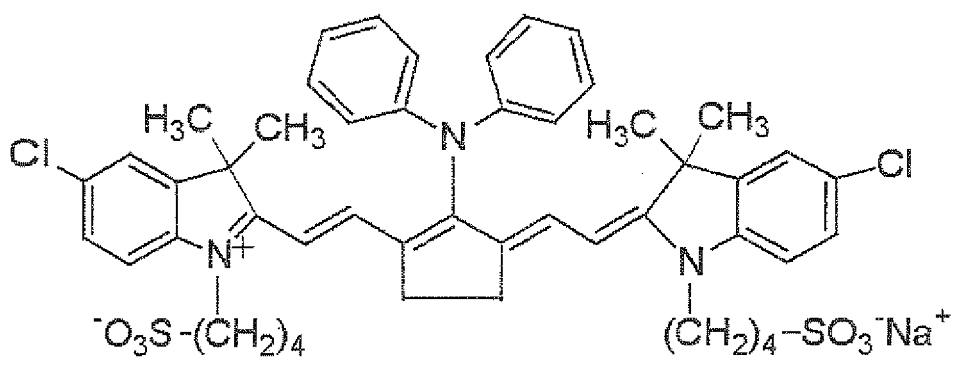

Infrared absorbing dye (3)

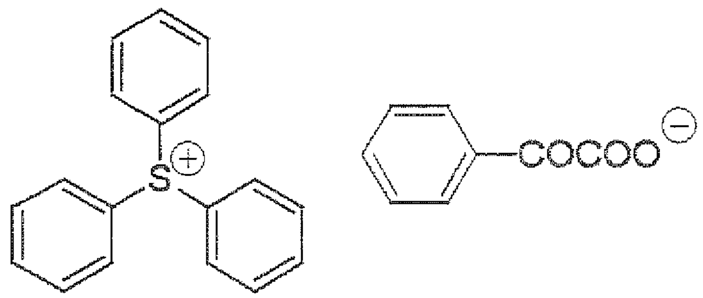

Radical polymerization initiator (2)

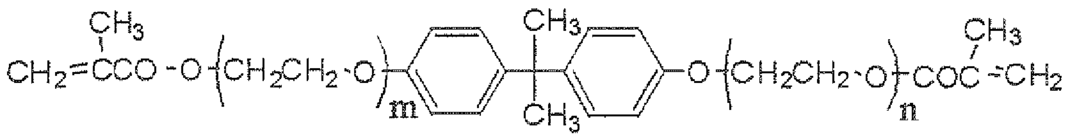

m+n=30

NK ESTER BPE-1300

(Preparation of Aqueous dispersion (2) of polymer fine particle)

A stirrer, a thermometer, a dropping funnel, a nitrogen inlet tube and a reflux condenser were attached to a 1, 000 ml four-neck flask and while carrying out deoxygenation by introduction of nitrogen gas, 350 ml of distilled water was charged therein and heated until the internal temperature reached 80°C. To the flask was added 1.5 g of sodium dodecylsufate as a dispersing agent, then was added 0.45 g of ammonium persulfate as an initiator, and thereafter was dropwise added 45.0 g of styrene through the dropping funnel over a period of about one hour. After the completion of the dropwise addition, the mixture was continued to react as it was for 5 hours, followed by removing the unreacted monomers by steam distillation. The mixture was cooled, adjusted the pH to 6 with aqueous ammonia and finally added pure water thereto so as to have the nonvolatile content of 15% by weight to obtain Aqueous dispersion (2) of polymer fine particle. The particle size distribution of the polymer fine particle measured in the same manner as in Aqueous dispersion (1) of polymer fine particle had the maximum value at the particle size of 60 nm.

Coating solution (1) for overcoat layer having the composition shown above was further coated on the image-recording layer described above by a bar and dried in an oven at 120°C for 60 seconds to form an overcoat layer having a dry coating amount of 0.15 g/m$^2$, thereby preparing Lithographic printing plate precursors (91) to (135) for Examples 41 to 60 and Comparative Examples 51 to 75, respectively.

4. Evaluation of Lithographic printing plate precursor

(1) Sensitivity

Each of Lithographic printing plate precursors (1) to (135) thus-obtained was exposed with a fine line of 10 μm by Trendsetter 3244VX (produced by Creo Co.) equipped with a water-cooled 40 W infrared semiconductor laser under the conditions of a rotational number of an external drum of 250 rpm and resolution of 2,400 dpi. while changing output (W). The exposed lithographic printing plate precursor was mounted on a plate cylinder of a printing machine (Speed-Master 74, produced by Heidelberg Co.) . Using dampening water (dampening water (zeroIPA-ECOLITY 20, produced by FUJIFILM Corp.)/tap water = 2/98 (volume ratio)) and FUSION-G (N) Black Ink (produced by Dainippon Ink & Chemicals, Inc.), the dampening water and ink were supplied according to the standard automatic printing start method of SpeedMaster 74 to conduct on-press development and then printing was conducted on 500 sheets at a printing speed of 8,000 sheets per hour. An irradiation energy amount (mJ/cm$^2$) which was obtained from the laser minimum output (W) necessary for reproducing the fine line of 10 μm without interruption on the printed material after the completion of on-press development was evaluated as the sensitivity. The results obtained are shown in Table 2.

(2) On-press development property and ink receptivity

Each of the lithographic printing plate precursors thus-obtained was exposed by LUXEL PLATESETTER T-6000III equipped with an infrared semiconductor laser (produced by FUJIFILM Corp.) under the conditions of a rotational

number of an external drum of 1,000 rpm, laser output of 70% and resolution of 2, 400 dpi. The exposed image contained a solid image and a 50% halftone dot chart of a 20 μm-dot FM screen.

The exposed lithographic printing plate precursor was mounted without undergoing development processing on a plate cylinder of a printing machine (Lithrone 26, produced by Komori Corp.). Using dampening water (ECOLITY-2 (produced by FUJIFILM Corp.)/tap water = 2/98 (volume ratio)) and FUSION-G (N) Black Ink (produced by Dainippon Ink & Chemicals, Inc.), the dampening water and ink were supplied according to the standard automatic printing start method of Lithrone 26 to conduct printing on 100 sheets of TOKUBISHI art paper (76.5 kg) at a printing speed of 10,000 sheets per hour.

A number of the printing papers required until the on-press development of the unexposed area of the image-recording layer on the printing machine was completed to reach a state where the ink was not transferred to the printing paper in the non-image area was measured to evaluate the on-press development property.

Also, a number of the printing papers required until the ink density of the image area which was the exposed area reached a specified ink density was measured to evaluate the ink receptivity. The results obtained are shown in Table 2.

(3) Printing durability

After performing the evaluation for the on-press development property described above, the printing was continued. As the increase in a number of printing papers, the image-recording layer was gradually abraded to cause decrease in the ink density on the printed material. A number of printing papers wherein a value obtained by measuring a halftone dot area rate of the 50% halftone dot of FM screen on the printed material using a Gretag densitometer decreased by 5% from the value measured on the 100th paper of the printing was determined to evaluate the printing durability. The results obtained are shown in Table 2.

TABLE 1-1: Lithographic Printing Plate Precursors (1) to (20) (OC Layer: Overcoat Layer)

| Lithographic Printing Plate Precursor | Image-recording Layer | OC Layer | Stratiform Compound | | | |
|---|---|---|---|---|---|---|
| | | | Compound Name | Mineral Species/Compound Species | Layer Structre | Amount Added (g) |
| (1) | (1) | (1) | ASP-200 produced by BASF | Kaolinite | 1:1 | 3.2 |
| | | | SOMASIF ME-100 produced by CO-OP Chemical Co., Ltd. | La Fluorotetrasilicate | 1:2 | 3.2 |
| (2) | (1) | (1) | ASP-200 produced by BASF | Kaolinite | 1:1 | 2.2 |
| | | | SOMASIF ME-100 produced by CO-OP Chemical Co., Ltd. | Na Fluorotetrasilicate | 1:2 | 4.2 |
| (3) | (1) | (1) | ASP-200 produced by BASF | Kaoline | 1:1 | 1.6 |
| | | | SOMASIF ME-100 produced by CO-OP Chemical Co., Ltd. | Na Fluorotetrasillicate | 1:2 | 4.8 |
| (4) | (1) | (1) | ASP-200 produced by BASF | Kaolinite | 1:1 | 6.4 |
| | | | SOMASIF ME-100 produced by CO-OP Chemical Co., Ltd. | Na Fluorotetrasilicate | 1:2 | 6.4 |

(continued)

| Lithographic Printing Plate Precursor | Image-recording Layer | OC Layer | Stratiform Compound | | | |
|---|---|---|---|---|---|---|
| | | | Compound Name | Mineral Species/Compound Species | Layer Structre | Amount Added (g) |
| (5) | (1) | (1) | SATINTONE W produced by BASF | Kaolinite | 1:1 | 3.2 |
| | | | SOMASIF ME-100 produced by CO-OP Chemical Co., Ltd. | Na Fluorotetrasilicate | 1:2 | 3.2 |
| (6) | (1) | (1) | 3S KAOLIN produced by Fukuoka Talc Co., Ltd. | Kaolinile | 1:1 | 3.2 |
| | | | SOMASIF ME-100 produced by CO-OP Chemical Co., Ltd. | Na Fluorotetrasilicate | 1:2 | 3.2 |
| (7) | (1) | (1) | HALLOYSITE NANOCLAY produced by Sigma-Aldrich GmbH | Halloysite | 1:1 | 3.2 |
| | | | SOMASIF ME-100 produced by CO-OP Chemical Co., Ltd. | Na Fluorotetrasilicate | 1:2 | 3.2 |
| (8) | (1) | (1) | ASP-200 produced by BASF | Kaolinite | 1:1 | 3.2 |
| | | | DR TALC produced by Toshin Chemicals Co., Ltd. | Talc | 1:2 | 3.2 |
| (9) | (1) | (1) | ASP-200 produced by BASF | Kaolinite | 1:1 | 3.2 |
| | | | HIGHFILLER #12 produced by Toshin Chemicals Co., Ltd. | Talc | 1:2 | 3.2 |
| (10) | (1) | (1) | ASP-200 produced by BASF | Kaolinite | 1:1 | 3.2 |
| | | | SUMECTON SA produced by Kunimine Industries Co., Ltd. | Saponite | 1:2 | 3.2 |
| (11) | (1) | (1) | ASP-200 produced by BASF | Kaolinite | 1:1 | 3.2 |
| | | | LAPONITE D produced by Rockwood Additives Ltd. | Hectorite | 1:2 | 3.2 |
| (12) | (1) | (1) | ASP-200 produced by BASF | Kaolinite | 1:1 | 3.2 |
| | | | LUCENTITE SWN produced by CO-OP Chemical Co., Ltd. | Hectorite | 1:2 | 3.2 |

(continued)

| Lithographic Printing Plate Precursor | Image-recording Layer | OC Layer | Stratiform Compound | | | |
|---|---|---|---|---|---|---|
| | | | Compound Name | Mineral Species/Compound Species | Layer Structre | Amount Added (g) |
| (13) | (1) | (1) | ASP-200 produced by BASF | Kaolinite | 1:1 | 3.2 |
| | | | KUNIPIA F produced by Kunimine Industries Co., Ltd. | Montmorillonite | 1:2 | 3.2 |
| (14) | (1) | (1) | ASP-200 produced by BASF | Kaolinite | 1:1 | 3.2 |
| | | | BEN-GEL A produced by Hojun Co., Ltd. | Montmorillonite | 1:2 | 3.2 |
| (15) | (1) | (1) | ASP-200 produced by BASF | Kaolinite | 1:1 | 3.2 |
| | | | CALCINED VERMICULITE No. 0 produced by Vermitech Corp. | Vermiculite | 1:2 | 3.2 |
| (16) | (1) | (1) | ASP-200 produced by BASF | Kaolinite | 1:1 | 3.2 |
| | | | HATTORI VERMICULITE produced by Hattori Co., Ltd. | Vermiculite | 1:2 | 3.2 |
| (17) | (1) | (1) | ASP-200 produced by BASF | Kaolinite | 1:1 | 3.2 |
| | | | MICROMICA MK100 produced by CO-OP Chemical Co., Ltd. | K Fluorotetrasilicate | 1:2 | 3.2 |
| (18) | (1) | (1) | ASP-200 produced by BASF | Kaolinite | 1:1 | 3.2 |
| | | | NTS-5 produced by Topy Industries, Ltd. | NaFluorotetrasilicate | 1:2 | 3.2 |
| (19) | (1) | (1) | ASP-200 produced by BASF | Kaolinite | 1:1 | 3.2 |
| | | | NHT-SOL B2 produced by Topy Industries, Ltd. | Na Hectorite | 1:2 | 3.2 |
| (20) | (1) | (1) | SOMASIF ME-100 produced by CO-OP Chemical Co., Ltd. | Na Fluorotetrasilicate | 1:2 | 3.2 |
| | | | ZP-G produced by KCM Corp. | Zirconium phosphate | - | 3.2 |

TABLE 1-2: Lithographic Printing Plate Precursors (21) to (45)

| Lithographic Printing Plate Precursor | Image-recording Layer | OC Layer | Stratiform Compound | | | |
|---|---|---|---|---|---|---|
| | | | Compound Name | Mineral Species/Compound Species | Layer Structure | Amount Added (g) |
| (21) | (1) | (1) | SOMASIF ME-100 produced by CO-OP Chemical Co., Ltd. | Na Fluorotetrasilicate | 1:2 | 1.6 |
| (22) | (1) | (1) | SOMASIF ME-100 produced by CO-OP Chemical Co., Ltd. | Na Fluorotetrasilicate | 1:2 | 6.4 |
| (23) | (1) | (1) | SOMASIF ME-100 produced by CO-OP Chemical Co., Ltd. | Na Fluorotetrasilicate | 1:2 | 12.8 |
| (24) | (1) | (1) | ASP-200 produced by BASF | Kaolinite | 1:1 | 6.4 |
| (25) | (1) | (1) | SATINTONE W produced by BASF | Kaolinite | 1:1 | 6.4 |
| (26) | (1) | (1) | 3S KAOLIN produced by Fukuoka Talc Co., Ltd. | Kaolinite | 1:1 | 6.4 |
| (27) | (1) | (1) | HALLOYSITE NANOCLAY produced by Sigma-Aldrich GmbH | Haloysite | 1:1 | 6.4 |
| (28) | (1) | (1) | DR TALC produced by Toshin Chemicab Co., Ltd. | Talc | 1:2 | 6.4 |
| (29) | (1) | (1) | HIGHFILLER#12 produced by Toshin Chemicals Co., Ltd. | Talc | 1:2 | 6.4 |
| (30) | (1) | (1) | SUMECTON SA produced by Kunimine Industries Co., Ltd. | Saponite | 1:2 | 6.4 |
| (31) | (1) | (1) | LAPONITE D produced by Rockwood Additives Ltd. | Hectorite | 1:2 | 6.4 |
| (32) | (1) | (1) | LUCENTITE SWN produced by CO-OP Chemical Co., Ltd. | Hectorile | 1:2 | 6.4 |
| (33) | (1) | (1) | KUNIPIA F produced by Kunimine Industries Co., Ltd. | Montmorillonite | 1:2 | 6.4 |
| (34) | (1) | (1) | BEN-GEL A produced by Hojun Co., Ltd. | Montmorilonite | 1:2 | 6.4 |
| (35) | (1) | (1) | CALCINED VERMICULITE No. 0 produced by Vermitech Corp. | Vermiculite | 1:2 | 6.4 |
| (36) | (1) | (1) | HATTORI VERMICULITE produced by Hatlori Co., Ltd. | Vermiculite | 1:2 | 6.4 |

(continued)

| Lithographic Printing Plate Precursor | Image-recording Layer | OC Layer | Stratiform Compound | | | |
|---|---|---|---|---|---|---|
| | | | Compound Name | Mineral Species/Compound Species | Layer Structure | Amount Added (g) |
| (37) | (1) | (1) | MICROMICA MK100 produced by CO-OP Chemical Co., Ltd. | K Fluororotetrasilicate | 1:2 | 6.4 |
| (38) | (1) | (1) | NTS-5 produced by Topy Industries, Ltd. | Na Fluorotetrasilcate | 1:2 | 6.4 |
| (39) | (1) | (1) | NHT-SOL B2 produced by Topy Industries, Ltd. | Na Hectorite | 1:2 | 6.4 |
| (40) | (1) | (1) | ZP-G produced by KCM Corp. | Zirconium phosphate | - | 6.4 |
| (41) | (1) | (1) | 3S KAOLIN produced by Fukuoka Talc Co., Ltd. | Kaolinite | 1:1 | 3.2 |
| | (1) | (1) | HALLOYSITE NANOCLAY produced by Sigma-Aldrich GmbH | Halloysite | 1:1 | 3.2 |
| (42) | (1) | (1) | SUMECTON SA produced by Kunimine Industries Co., Ltd. | Saponite | 1:2 | 3.2 |
| | (1) | (1) | LAPONITE D produced by Rockwood Additives Ltd. | Hectorite | 1:2 | 3.2 |
| (43) | (1) | (1) | SUMECTON SA produced by Kunimine industries Co., Lid. | Saponite | 1:2 | 3.2 |
| | (1) | (1) | KUNIPIA F produced by Kunimine Industries Co., Lid. | Montmorillonite | 1:2 | 3.2 |
| (44) | (1) | (1) | KUNIPIA F produced by Kunimine Industries Co., Ltd. | Montmonllonite | 1:2 | 3.2 |
| | (1) | (1) | SOMASIF ME-100 produced by CO-OP Chemical Co., Ltd. | Na Fluorotetrasilicate | 1:2 | 3.2 |
| (45) | (1) | (1) | None | - | - | 0 |

TABLE 1-3: Lithographic Printing Plate Precursors (46) to (65) (OC Layer: Overcoat Layer)

| Lithographic Printing Plate Precursor | Image-recording Layer | OC Layer | Stratiform Compound | | | |
|---|---|---|---|---|---|---|
| | | | Compound Name | Mineral Species/Compound Species | Layer Structure | Amount Added (g) |
| (46) | (2) | (1) | ASP-200 produced by BASF | Kaolinite | 1:1 | 3.2 |
| | | | SOMASIF ME-100 produced by COOP Chemical Co., Ltd. | Na Fluorotetrasilicate | 1:2 | 3.2 |
| (47) | (2) | (1) | ASP-200 produced by BASF | Kaolinite | 1:1 | 2.2 |
| | | | SOMASIF ME-100 produced by CO-OP Chemical Co., Ltd. | Na Fluorotetrasilicate | 1:2 | 4.2 |
| (48) | (2) | (1) | ASP-200 produced by BASF | Kaolinite | 1:1 | 1.6 |
| | | | SOMASIF ME-100 produced by CO-OP Chenical Co., Ltd. | Na Fluorotetrasilicate | 1:2 | 4.8 |
| (49) | (2) | (1) | ASP-200 produced by BASF | Kaolinite | 1:1 | 6.4 |
| | | | SOMASIF ME-100 produced by CO-OP Chemical Co., Ltd. | Na Fluorotetrasilicate | 1:2 | 6.4 |
| (50) | (2) | (1) | SATINTONE W produced by BASF | Kaolinite | 1:1 | 3.2 |
| | | | SOMASIF ME-100 produced by CO-OP Chemical Co., Ltd. | Na Fluorotetrasilicate | 1:2 | 3.2 |
| (51) | (2) | (1) | 3S KAOLIN produced by Fukuoka Talc Co., Ltd. | Kaolinite | 1:1 | 32 |
| | | | SOMASIF ME-100 produced by CO-OP Chemical Co., Ltd. | Na Fluorotetrasilicate | 1:2 | 3.2 |
| (52) | (2) | (1) | HALLOYSITE NANOCLAY produced by Sigma-Aldrich GmbH | Halloysite | 1:1 | 3.2 |
| | | | SOMASIF ME-100 produced by CO-OP Chemical Co., Ltd. | Na Fluorotetrasilicate | 1:2 | 3.2 |
| (53) | (2) | (1) | ASP-200 produced by BASF | Kaolinite | 1:1 | 3.2 |
| | | | DR TALC produced by Toshin Chemicals Co., Ltd. | Talc | 1:2 | 3.2 |

(continued)

| Lithographic Printing Plate Precursor | Image-recording Layer | OC Layer | Stratiform Compound | | | |
|---|---|---|---|---|---|---|
| | | | Compound Name | Mineral Species/Compound Species | Layer Structure | Amount Added (g) |
| (54) | (2) | (1) | ASP-200 produced by BASF | Kaolinite | 1:1 | 3.2 |
| | | | HIGHFILLER #12 produced by Toshin Chemicals Co., Ltd. | Talc | 1:2 | 3.2 |
| (55) | (2) | (1) | ASP-200 produced by BASF | Kaolinite | 1:1 | 3.2 |
| | | | SUMECTON SA produced by Kunimine Industries Co., Ltd. | Saponite | 1:2 | 3.2 |
| (56) | (2) | (1) | ASP-200 produced by BASF | Kaolinite | 1:1 | 3.2 |
| | | | LAPONITE D produced by Rockwood Additives Ltd. | Hectorite | 1:2 | 3.2 |
| (57) | (2) | (1) | ASP-200 produced by BASF | Kaolinite | 1:1 | 3.2 |
| | | | LUCENTITE SWN produced by CO-OP Chemical Co., Ltd. | Hectorite | 1:2 | 3.2 |
| (58) | (2) | (1) | ASP-200 produced by BASF | Kaolinite | 1:1 | 3.2 |
| | | | KUNIPIA F produced by Kunimine Industries Co., | Ltd. Montmorillonite | 1:2 | 3.2 |
| (59) | (2) | (1) | ASP-200 produced by BASF | Kaolinite | 1:1 | 3.2 |
| | | | BEN-GEL A produced by Hojun Co., Ltd. | Montmorillonite | 1:2 | 3.2 |
| (60) | (2) | (1) | ASP-200 produced by BASF | Kaolinite | 1:1 | 3.2 |
| | | | CALCINED VERMICULITE No. 0 produced by Vermitech Corp. | Vermiculite | 1:2 | 3.2 |
| (61) | (2) | (1) | ASP-200 produced by BASF | Kaolinite | 1:1 | 3.2 |
| | | | HATTORI VERMICULITE produced by Hattori Co., Ltd. | Vermiculite | 1:2 | 3.2 |
| (62) | (2) | (1) | ASP-200 produced by BASF | Kaolinite | 1:1 | 3.2 |
| | | | MICROMICA MK100 produced by CO-OP Chemical Co., Ltd. | K Fluorotetrasilicate | 1:2 | 3.2 |

(continued)

| Lithographic Printing Plate Precursor | Image-recording Layer | OC Layer | Stratiform Compound | | | |
|---|---|---|---|---|---|---|
| | | | Compound Name | Mineral Species/Compound Species | Layer Structure | Amount Added (g) |
| (63) | (2) | (1) | ASP-200 produced by BASF | Kaolinite | 1:1 | 3.2 |
| | | | NTS-5 produced by Topy Industries, Ltd. | Na Fluorotetrasilicate | 1:2 | 3.2 |
| (64) | (2) | (1) | ASP-200 produced by BASF | Kaolinite | 1:1 | 3.2 |
| | | | NHT-SOL B2 produced by Topy Industries, Ltd. | Na Hectorite | 1:2 | 3.2 |
| (65) | (2) | (1) | SOMASIF ME-100 produced by CO-OP Chemical Co., Ltd. | Na Fluorotetrasilicate | 1:2 | 3.2 |
| | | | ZP-G produced by KCM Corp. | Zirconium phosphate | - | 3.2 |

TABLE 1-4: Lithographic Printing Plate Precursors (66) to (90)

| Lithographic Printing Plate Precursor | image-recording Layer | OC Layer | Stratiform Compound | | | |
|---|---|---|---|---|---|---|
| | | | Compound Name | Mineral Species/Compound Species | Layer Structure | Amount Added (g) |
| (66) | (2) | (1) | SOMASIF ME-100 produced by CO-OP Chemical Co., Ltd. | Na Fluorotetrasilicate | 1:2 | 1.6 |
| (67) | (2) | (1) | SOMASIF ME-100 produced by CO-OP Chemical Co., Ltd. | Na Fluorotetrasilicate | 1:2 | 6.4 |
| (68) | (2) | (1) | SOMASIF ME-100 produced by CO-OP Chemical Co., Ltd. | Na Fluorotetrasilicate | 1:2 | 12.8 |
| (69) | (2) | (1) | ASP-200 produced by BASF | Kaolinite | 1:1 | 6.4 |
| (70) | (2) | (1) | SATINTONE W produced by BASF | Kaolinite | 1:1 | 6.4 |
| (71) | (2) | (1) | 3S KAOLIN produced by Fukuoka Talc Co., Ltd. | Kaolinite | 1:1 | 6.4 |
| (72) | (2) | (1) | HALLOYSITE NANOCLAY produced by Sigma-Aldrich GmbH | Halloysite | 1:1 | 6.4 |
| (73) | (2) | (1) | DR TALC produced by Toshin Chemicals Co., Ltd. | Talc | 1:2 | 6.4 |
| (74) | (2) | (1) | HIGHFILLER#12 produced by Toshin Chemicals Co., Ltd. | Talc | 1:2 | 6.4 |

(continued)

| Lithographic Printing Plate Precursor | image-recording Layer | OC Layer | Stratiform Compound | | | |
|---|---|---|---|---|---|---|
| | | | Compound Name | Mineral Species/Compound Species | Layer Structure | Amount Added (g) |
| (75) | (2) | (1) | SUMECTON SA produced by Kunimine Industries Co., Ltd. | Saponite | 1:2 | 6.4 |
| (76) | (2) | (1) | LAPONITE D produced by Rockwood Additives Ltd. | Hectorite | 1:2 | 6.4 |
| (77) | (2) | (1) | LUCENTITE SWN produced by CO-OP Chemical Co., Ltd. | Hectorite | 1:2 | 6.4 |
| (78) | (2) | (1) | KUNIPIA F produced by Kunimine Industries Co., Ltd. | Montmorillonite | 1: 2 | 6.4 |
| (79) | (2) | (1) | BEN-GEL A produced by Hojun Co., Ltd. | Montmorillonite | 1:2 | 6.4 |
| (80) | (2) | (1) | CALCINED VERMICULITE No. 0 produced by Vermitech Corp. | Vermiculite | 1:2 | 6.4 |
| (81) | (2) | (1) | HATRORI VERMICULITE produced by Hattori Co., Ltd. | Vermiculite | 1:2 | 6.4 |
| (82) | (2) | (1) | MICROMICA MK100 produced by CO-OP Chemical Co., Ltd. | K Fluorotetrasilicate | 1:2 | 6.4 |
| (83) | (2) | (1) | NTS-5 produced by Topy Industries, Ltd. | Na Fluorosilicate | 1:2 | 6.4 |
| (84) | (2) | (1) | NHT-SOL B2 produced by Topy Industries, Ltd. | Na Hectorite | 1:2 | 6.4 |
| (85) | (2) | (1) | ZP-G produced by KCM Corp. | Zirconium phosphate | - | 6.4 |
| (86) | (2) | (1) | 3S KAOLIN produced by Fukuoka Talc Co., Ltd. | Kaolinite | 1:1 | 3.2 |
| | | (1) | HALLOYSITE NANOCLAY produced by Sigma-Aldrich GmbH | Halloysite | 1:1 | 3.2 |
| (87) | (2) | (1) | SUMECTON SA produced by Kunimine Industries Co., Ltd. | Saponite | 1:2 | 3.2 |
| | | (1) | LAPONITE D produced by Rockwood Additives Ltd. | Hectorite | 1:2 | 3.2 |
| (88) | (2) | (1) | SUMECTON SA produced by Kunimine industries Co., Ltd. | Saponite | 1:2 | 3.2 |

(continued)

| Lithographic Printing Plate Precursor | image-recording Layer | OC Layer | Stratiform Compound | | | |
|---|---|---|---|---|---|---|
| | | | Compound Name | Mineral Species/Compound Species | Layer Structure | Amount Added (g) |
| | | (1) | KUNIPIA F produced by Kunimine Industries Co., Ltd. | Montmorillonite | 1:2 | 3.2 |
| (89) | (2) | (1) | KUNIPIA F produced by Kunimine Industries Co., Ltd. | Montmorillonite | 1:2 | 3.2 |
| | | (1) | SOMASIF ME-100 produced by CO-OP Chemical Co., Ltd. | Na Fluorotetrasilicate | 1:2 | 3.2 |
| (90) | (2) | (1) | None | - | - | 0 |

TABLE 1-5: Lithographic Printing Plate Precursors (91) to (110) (OC Layer: Overcoat Layer)

| Lithographic Printing Plate Precursor | Image-recording Layer | OC Layer | Stratiform Compound | | | |
|---|---|---|---|---|---|---|
| | | | Compound Name | Mineral Species | Layer Structure | Amount Added (g) |
| (91) | (3) | (1) | ASP-200 produced by BASF | Kaolinite | 1:1 | 3.2 |
| | | | SOMASIF ME-100 produced by CO-OP Chemical Co., Ltd. | Na Fluorotetrasilicate | 1:2 | 3.2 |
| (92) | (3) | (1) | ASP-200 produced by BASF | Kaolinite | 1:1 | 2.2 |
| | | | SOMASIF ME-100 produced by CO-OP Chemical Co., Ltd. | Na Fluorotetrasilicate | 1:2 | 4.2 |
| (93) | (3) | (1) | ASP-200 produced by BASF | Kaolinite | 1:1 | 1.6 |
| | | | SOMASIF ME-100 produced by CO-OP Chemical Co., Ltd. | Na Fluorosilicate | 1:2 | 4.8 |
| (94) | (3) | (1) | ASP-200 produced by BASF | Kaolinite | 1:1 | 6.4 |
| | | | SOMASIF ME-100 produced by CO-OP Chemical Co., Ltd. | Na Fluorotetrasilicate | 1:2 | 6.4 |
| (95) | (3) | (1) | SATINTONE W produced by BASF | Kaolinite | 1:1 | 3.2 |
| | | | SOMASIF ME-100 produced by CO-OP Chemical Co., Ltd. | Na Fluorotetrasilicate | 1:2 | 3.2 |

(continued)

| Lithographic Printing Plate Precursor | Image-recording Layer | OC Layer | Stratiform Compound | | | |
|---|---|---|---|---|---|---|
| | | | Compound Name | Mineral Species | Layer Structure | Amount Added (g) |
| (96) | (3) | (1) | 3S KAOLIN produced by Fukuoka Talc Co., Ltd. | Kaolinite | 1:1 | 3.2 |
| | | | SOMASIF ME-100 produced by CO-OP Chemical Co., Ltd. | Na Fluorotetrasilicate | 1:2 | 3.2 |
| (97) | (3) | (1) | HALLOYSITE NANOCLAY produced by Sigma-Aldrich GmbH | Halloysite | 1:1 | 3.2 |
| | | | SOMASIF ME-100 produced by CO-OP Chemical Co., Ltd. | Na Fluorotetrasilicate | 1:2 | 3.2 |
| (98) | (3) | (1) | ASP-200 produced by BASF | Kaolinite | 1:1 | 3.2 |
| | | | DR TALC produced by Toshin Chemicals Co., Ltd. | Talc | 1:2 | 3.2 |
| (99) | (3) | (1) | ASP-200 produced by BASF | Kaolinite | 1:1 | 3.2 |
| | | | HIGHFILLER#12 produced by Toshin Chemicals Co., Ltd. | Talc | 1:2 | 3.2 |
| (100) | (3) | (1) | ASP-200 produced by BASF | Kaolinite | 1:1 | 3.2 |
| | | | SUMECTON SA produced by Kunimine Industries Co., Ltd. | Saponite | 1:2 | 3.2 |
| (101) | (3) | (1) | ASP-200 produced by BASF | Kaolinite | 1:1 | 3.2 |
| | | | LAPONITE D produced by Rockwood Additives Ltd. | Hectorite | 1:2 | 3.2 |
| (102) | (3) | (1) | ASP-200 produced by BASF | Kaolinite | 1:1 | 3.2 |
| | | | LUCENTITE SWN produced by CO-OP Chemical Co..Ltd. | Hectorite | 1:2 | 3.2 |
| (103) | (3) | (1) | ASP-200 produced by BASF | Kaolinite | 1:1 | 3.2 |
| | | | KUNIPIA F produced by Kunimine Industries Co., Ltd. | Montmorillonite | 1:2 | 3.2 |
| (104) | (3) | (1) | ASP-200 produced by BASF | Kaolinite | 1:1 | 3.2 |
| | | | BEN-GEL A produced by Hojun Co., Ltd. | Montmorillonite | 1:2 | 3.2 |

(continued)

| Lithographic Printing Plate Precursor | Image-recording Layer | OC Layer | Stratiform Compound | | | |
|---|---|---|---|---|---|---|
| | | | Compound Name | Mineral Species | Layer Structure | Amount Added (g) |
| (105) | (3) | (1) | ASP-200 produced by BASF | Kaolinite | 1:1 | 3.2 |
| | | | CALCINED VERMICUUTE produced by Vermitech Corp. | Vermiculite | 1:2 | 3.2 |
| (106) | (3) | (1) | ASP-200 produced by BASF | Kaolinite | 1:1 | 3.2 |
| | | | HATTORI VERMICULITE No. 0 produced by Hattori Co., Ltd. | Vermiculite | 1:2 | 3.2 |
| (107) | (3) | (1) | ASP-200 produced by BASF | Kaolinite | 1:1 | 3.2 |
| | | | MICROMICA MK100 produced by CO-OP Chemical Co., Ltd. | K Fluorotetrasilicate | 1:2 | 3.2 |
| (108) | (3) | (1) | ASP-200 produced by BASF | Kaolinite | 1:1 | 3.2 |
| | | | NTS-5 produced by Topy Industries, Ltd. | Na Fluorotetrasilicate | 1:2 | 3.2 |
| (109) | (3) | (1) | ASP-200 produced by BASF | Kaolinite | 1:1 | 3.2 |
| | | | NHT-SOL B2 produced by Topy Industries, Ltd. | Na Hectorite | 1:2 | 3.2 |
| (110) | (3) | (1) | SOMASIF ME-100 produced by CO-OP Chemical Co., Ltd. | Na Fluorotetrasilicate | 1:2 | 3.2 |
| | | | ZP-G produced by KCM Corp. | Zirconium phosphate | - | 3.2 |

TABLE 1-6: Lithographic Printing Plate Precursors (111) to (135)

| Lithographic Printing Plate Precursor | Image-recording Layer | OC Layer | Stratiform Compound | | | |
|---|---|---|---|---|---|---|
| | | | Compound Name | Mineral Species/Compound Species | Layer Structure | Amount Added (g) |
| (111) | (3) | (1) | SOMASIF ME-100 produced by CO-OP Chemical Co., Ltd. | Na Fluorotetrasilicate | 1:2 | 1.6 |
| (112) | (3) | (1) | SOMASIF ME-100 produced by CO-OP Chemical Co.. Ltd. | Na Fluorotetrasilicate | 1:2 | 6.4 |

(continued)

| Lithographic Printing Plate Precursor | Image-recording Layer | OC Layer | Stratiform Compound | | | |
|---|---|---|---|---|---|---|
| | | | Compound Name | Mineral Species/Compound Species | Layer Structure | Amount Added (g) |
| (113) | (3) | (1) | SOMASIF ME-100 produced by CO-OP Chemical Co., Ltd. | Na Fluorotetrasilicate | 1:2 | 12.8 |
| (114) | (3) | (1) | ASP-200 produced by BASF | Kaolinite | 1:1 | 6.4 |
| (115) | (3) | (1) | SATINTONE W produced by BASF | Kaolinite | 1:1 | 6.4 |
| (116) | (3) | (1) | 3S KAOLIN produced by Fukuoka Talc Co., Ltd. | Kaolinite | 1:1 | 6.4 |
| (117) | (3) | (1) | HALLOYSITE NANOCLAY produced by Sigma-Aldrich GmbH | Halloysite | 1:1 | 6.4 |
| (118) | (3) | (1) | DR TALC produced by Toshin Chemicals Co., Ltd. | Talc | 1:2 | 6.4 |
| (119) | (3) | (1) | HIGHFILLER #12 produced by Toshin Chemicals Co., Ltd. | Talc | 1:2 | 6.4 |
| (120) | (3) | (1) | SUMECTON SA produced by Kunimine Industries Co., Ltd. | Saponite | 1:2 | 6.4 |
| (121) | (3) | (1) | LAPONITE D produced by Rockwood Additives Ltd. | Hectorite | 1:2 | 6.4 |
| (122) | (3) | (1) | LUCENTITE SWN produced by CO-OP Chemical Co., Ltd. | Hectorite | 1:2 | 6.4 |
| (123) | (3) | (1) | KUNIPIA F produced by Kunimine Industries Co., Ltd. | Montmorillonite | 1:2 | 6.4 |
| (124) | (3) | (1) | BEN-GEL A produced by Hojun Co., Ltd. | Montmorillonite | 1:2 | 6.4 |
| (125) | (3) | (1) | CALCINED VERMICULITE No. 0 produced by Vermitech Corp. | Vermiculite | 1:2 | 6.4 |
| (126) | (3) | (1) | HATTORI VERMICULITE produced by Hattori Co., Ltd. | Vermiculite | 1:2 | 6.4 |
| (127) | (3) | (1) | MICROMICA MK100 produced by CO-OP Chemical Co., Ltd. | K Fluorotelrasilicate | 1:2 | 6.4 |
| (128) | (3) | (1) | NTS-5 produced by Topy Industries, Ltd. | Na Fluorotetrasilicate | 1:2 | 6.4 |

(continued)

| Lithographic Printing Plate Precursor | Image-recording Layer | OC Layer | Stratiform Compound | | | |
|---|---|---|---|---|---|---|
| | | | Compound Name | Mineral Species/Compound Species | Layer Structure | Amount Added (g) |
| (129). | (3) | (1) | NHT-SOL B2 produced by Topy Industries, LTd. | Na Hectorite | 1:2 | 6.4 |
| (130) | (3) | (1) | ZP-G produced by KCM Corp. | Zirconium phosphate | - | 6.4 |
| (131) | (3) | (1) | 3S KAOLIN produced by Fukuoka Talc Co., Ltd. | Kaolinite | 1:1 | 3.2 |
| | | (1) | HALLOYSITE NANOCLAY produced by Sigma-Aldrich GmbH | Halloysile | 1:1 | 3.2 |
| (132) | (3) | (1) | SUMECTON SA produced by Kunimine industries Co., Ltd. | Saponite | 1:2 | 3.2 |
| | | (1) | LAPONITE D produced by Rockwood Additives Ltd. | Hectorite | 1:2 | 3.2 |
| (133) | (3) | (1) | SUMECTON SA produced by Kunimine Industries Co., Ltd. | Saponite | 1:2 | 3.2 |
| | | (1) | KUNIPIA F produced by Kunimine Industries Co., Ltd. | Montmorillonite | 1:2 | 3.2 |
| (134) | (3) | (1) | KUNIPIA F produced by Kunimine Industries Co., Ltd. | Montmorillonite | 1:2 | 3.2 |
| | | (1) | SOMASIF ME-100 produced by CO-OP Chemical Co., Ltd. | Na FLuorotetrasilicate | 1:2 | 3.2 |
| (135) | (3) | (1) | None | - | - | 0 |

TABLE 2-1: Examples (1) to (20) and Comparative Examples (1) to (25) Evaluation Results of Printing

| Example | Lithographic Printing Plate Precursor | Sensitivity ($mJ/cm^2$) | Printing Durability (x $10^4$sheets | On-Press Development Property (sheets) | ink Receptivity (sheets) |
|---|---|---|---|---|---|
| Example 1 | (1) | 40 | 7.0 | 10 | 5 |
| Example 2 | (2) | 35 | 8.0 | 12 | 8 |
| Example 3 | (3) | 30 | 9.0 | 15 | 10 |
| Example 4 | (4) | 30 | 8.0 | 12 | 8 |
| Example 5 | (5) | 40 | 7.0 | 10 | 5 |
| Example 6 | (6) | 40 | 7.0 | 10 | 5 |
| Example 7 | (7) | 45 | 6.0 | 12 | 8 |
| Example 8 | (8) | 50 | 5.0 | 15 | 10 |
| Example 9 | (9) | 50 | 5.0 | 15 | 10 |

(continued)

| Example | Lithographic Printing Plate Precursor | Sensitivity (mJ/cm$^2$) | Printing Durability (x $10^4$ sheets | On-Press Development Property (sheets) | ink Receptivity (sheets) |
|---|---|---|---|---|---|
| Example 10 | (10) | 45 | 6.0 | 12 | 8 |
| Example 11 | (11) | 45 | 6.0 | 12 | 8 |
| Example 12 | (12) | 45 | 6.0 | 12 | 8 |
| Example 13 | (13) | 40 | 7.0 | 10 | 5 |
| Example 14 | (14) | 40 | 7.0 | 10 | 5 |
| Example 15 | (15) | 40 | 7.0 | 10 | 5 |
| Example 16 | (16) | 40 | 7.0 | 10 | 5 |
| Example 17 | (17) | 50 | 5.0 | 15 | 10 |
| Example 18 | (18) | 40 | 7.0 | 10 | 5 |
| Example 19 | (19) | 45 | 6.0 | 12 | 8 |
| Example 20 | (20) | 50 | 5.0 | 15 | 10 |
| Comparative Example 1 | (21) | 80 | 1.0 | 12 | 8 |
| Comparative Example 2 | (22) | 40 | 7.0 | 40 | 30 |
| Comparative Example 3 | (23) | 30 | 9.0 | 80 | 100 |
| Comparative Example 4 | (24) | 40 | 7.0 | 40 | 30 |
| Comparative Example 5 | (25) | 40 | 7.0 | 40 | 30 |
| Comparative Example 6 | (26) | 40 | 7.0 | 40 | 30 |
| Comparative Example 7 | (27) | 45 | 6.0 | 40 | 30 |
| Comparaitive Example 8 | (28) | 50 | 4.0 | 80 | 100 |
| Comparative Example 9 | (29) | 50 | 4.0 | 80 | 100 |
| Comparative Example 10 | (30) | 50 | 4.0 | 60 | 80 |
| Comparative Example 11 | (31) | 45 | 6.0 | 40 | 30 |
| Comparative Example 12 | (32) | 45 | 6.0 | 40 | 30 |
| Comparative Example 13 | (33) | 40 | 7.0 | 40 | 30 |
| Comparative Example 14 | (34) | 40 | 7.0 | 40 | 30 |
| Comparative Example 15 | (35) | 40 | 7.0 | 40 | 30 |

(continued)

| Example | Lithographic Printing Plate Precursor | Sensitivity (mJ/cm$^2$) | Printing Durability (x $10^4$sheets | On-Press Development Property (sheets) | ink Receptivity (sheets) |
|---|---|---|---|---|---|
| Comparative Example 16 | (36) | 40 | 7.0 | 40 | 30 |
| Comparative Example 17 | (37) | 50 | 4.0 | 40 | 30 |
| Comparative Example 18 | (38) | 40 | 7.0 | 40 | 30 |
| Comparative Example 19 | (39) | 40 | 7.0 | 40 | 30 |
| Comparative Example 20 | (40) | 50 | 4.0 | 40 | 30 |
| Comparative Example 21 | (41) | 40 | 7.0 | 40 | 30 |
| Comparative Example 22 | (42) | 40 | 7.0 | 40 | 30 |
| Comparative Example 23 | (43) | 40 | 7.0 | 40 | 30 |
| Comparative Example 24 | (44) | 40 | 7.0 | 40 | 30 |
| Comparative Example 25 | (45) | 100 | 0.2 | 5 | 5 |

TABLE 2-2: Examples (21) to (40) and Comparative Examples (26) to (50) Evaluation Results of Printing

| Example | Lithographic Printing Plate Precursor | Sensitivity (mJ/cm$^2$) | Printing Durability (x $10^4$ sheets) | On-Press Development Property (sheets) | Ink Receptivity (sheets) |
|---|---|---|---|---|---|
| Example 21 | (46) | 50 | 5.0 | 10 | 5 |
| Example 22 | (47) | 45 | 6.0 | 12 | 8 |
| Example 23 | (48) | 40 | 7.0 | 15 | 10 |
| Example 24 | (49) | 40 | 6.0 | 12 | 8 |
| Example 25 | (50) | 50 | 5.0 | 10 | 5 |
| Example 26 | (51) | 50 | 5.0 | 10 | 5 |
| Example 27 | (52) | 55 | 4.0 | 12 | 8 |
| Example 28 | (53) | 60 | 3.0 | 15 | 10 |
| Example 29 | (54) | 60 | 3.0 | 15 | 10 |
| Example 30 | (55) | 55 | 4.0 | 12 | 8 |
| Example 31 | (56) | 55 | 4.0 | 12 | 8 |
| Example 32 | (57) | 55 | 4.0 | 12 | 8 |
| Example 33 | (58) | 50 | 5.0 | 10 | 5 |
| Example 34 | (59) | 50 | 5.0 | 10 | 5 |
| Example 35 | (60) | 50 | 5.0 | 10 | 5 |

(continued)

| Example | Lithographic Printing Plate Precursor | Sensitivity ($mJ/cm^2$) | Printing Durability (x $10^4$ sheets) | On-Press Development Property (sheets) | Ink Receptivity (sheets) |
|---|---|---|---|---|---|
| Example 36 | (61) | 50 | 5.0 | 10 | 5 |
| Example 37 | (62) | 60 | 3.0 | 15 | 10 |
| Example 38 | (63) | 50 | 5.0 | 10 | 5 |
| Example 39 | (64) | 55 | 4.0 | 12 | 8 |
| Example 40 | (65) | 60 | 3.0 | 15 | 10 |
| Comparative Example 26 | (66) | 90 | 0.5 | 12 | 8 |
| Comparative Example 27 | (67) | 50 | 5.0 | 40 | 30 |
| Comparative Example 28 | (68) | 40 | 7.0 | 80 | 100 |
| Comparative Example 29 | (69) | 50 | 5.0 | 40 | 30 |
| Comparative Example 30 | (70) | 50 | 5.0 | 40 | 30 |
| Comparative Example 31 | (71) | 50 | 5.0 | 40 | 30 |
| Comparative Example 32 | (72) | 55 | 4.0 | 40 | 30 |
| Comparative Example 33 | (73) | 60 | 2.0 | 80 | 100 |
| Comparative Example 34 | (74) | 60 | 2.0 | 80 | 100 |
| Comparative Example 35 | (75) | 60 | 2.0 | 60 | 80 |
| Comparative Example 36 | (76) | 55 | 4.0 | 40 | 30 |
| Comparativee Example 37 | (77) | 55 | 4.0 | 40 | 30 |
| Comparative Example 38 | (78) | 50 | 5.0 | 40 | 30 |
| Comparative Example 39 | (79) | 50 | 5.0 | 40 | 30 |
| Comparative Example 40 | (80) | 50 | 5.0 | 40 | 30 |
| Comparative Example 41 | (81) | 50 | 5.0 | 40 | 30 |
| Comparative Example 42 | (82) | 60 | 2.0 | 40 | 30 |
| Comparative Example 43 | (83) | 50 | 5.0 | 40 | 30 |

(continued)

| Example | Lithographic Printing Plate Precursor | Sensitivity (mJ/cm$^2$) | Printing Durability (x $10^4$ sheets) | On-Press Development Property (sheets) | Ink Receptivity (sheets) |
|---|---|---|---|---|---|
| Comparative Example 44 | (84) | 50 | 5.0 | 40 | 30 |
| Comparative Example 45 | (85) | 60 | 2.0 | 40 | 30 |
| Comparative Example 46 | (86) | 50 | 5.0 | 40 | 30 |
| Comparative Example 47 | (87) | 50 | 5.0 | 40 | 30 |
| Comparative Example 48 | (88) | 50 | 5.0 | 40 | 30 |
| Comparative Example 49 | (89) | 50 | 5.0 | 40 | 30 |
| Comparative Example 50 | (90) | 120 | 0.1 | 5 | 5 |

TABLE 2-3: Examples (41) to (60) and Comparative Examples (51) to (75) Evaluation Results of Printing

| Example | Lithographic Printing Plate Precursor | Sensitivity (mJ/cm$^2$) | Printing Durability (x $10^4$ sheets) | On-Press Development Property (sheets) | Ink Receptivity (sheets) |
|---|---|---|---|---|---|
| Example 41 | (91) | 50 | 5.0 | 10 | 15 |
| Example 42 | (92) | 45 | 6.0 | 12 | 18 |
| Example 43 | (93) | 40 | 7.0 | 15 | 20 |
| Example 44 | (94) | 40 | 6.0 | 12 | 18 |
| Example 45 | (95) | 50 | 5.0 | 10 | 15 |
| Example 46 | (96) | 50 | 5.0 | 10 | 15 |
| Example 47 | (97) | 55 | 4.0 | 12 | 18 |
| Example 48 | (98) | 60 | 3.0 | 15 | 20 |
| Example 49 | (99) | 60 | 3.0 | 15 | 20 |
| Example 50 | (100) | 55 | 4.0 | 12 | 18 |
| Example 51 | (101) | 55 | 4.0 | 12 | 18 |
| Example 52 | (102) | 55 | 4.0 | 12 | 18 |
| Example 53 | (103) | 50 | 5.0 | 10 | 15 |
| Example 54 | (104) | 50 | 5.0 | 10 | 15 |
| Example 55 | (105) | 50 | 5.0 | 10 | 15 |
| Example 56 | (106) | 50 | 5.0 | 10 | 15 |
| Example 57 | (107) | 60 | 3.0 | 15 | 20 |
| Example 58 | (108) | 50 | 5.0 | 10 | 15 |
| Example 59 | (109) | 55 | 4.0 | 12 | 18 |
| Example 60 | (110) | 60 | 3.0 | 15 | 20 |

(continued)

| Example | Lithographic Printing Plate Precursor | Sensitivity ($mJ/cm^2$) | Printing Durability (x $10^4$ sheets) | On-Press Development Property (sheets) | Ink Receptivity (sheets) |
|---|---|---|---|---|---|
| Comparative Example 51 | (111) | 90 | 0.5 | 12 | 18 |
| Comparative Example 52 | (112) | 50 | 5.0 | 40 | 50 |
| Comparative Example 53 | (113) | 40 | 7.0 | 80 | 130 |
| Comparative Example 54 | (114) | 50 | 5.0 | 40 | 50 |
| Comparative Example 55 | (115) | 50 | 5.0 | 40 | 50 |
| Comparative Example 56 | (116) | 50 | 5.0 | 40 | 50 |
| Comparative Example 57 | (117) | 55 | 4.0 | 40 | 50 |
| Comparative Example 58 | (118) | 60 | 2.0 | 80 | 130 |
| Comparative Example 59 | (119) | 60 | 2.0 | 80 | 130 |
| Comparative Example 60 | (120) | 60 | 2.0 | 60 | 100 |
| Comparative Example 61 | (121) | 55 | 4.0 | 40 | 50 |
| Comparative Example 62 | (122) | 55 | 4.0 | 40 | 50 |
| Comparative Example 63 | (123) | 50 | 5.0 | 40 | 50 |
| Comparative Example 64 | (124) | 50 | 5.0 | 40 | 50 |
| Comparative Example 65 | (125) | 50 | 5.0 | 40 | 50 |
| Comparative Example 66 | (126) | 50 | 5.0 | 40 | 50 |
| Comparative Example 67 | (127) | 60 | 2.0 | 40 | 50 |
| Comparative Example 68 | (128) | 50 | 5.0 | 40 | 50 |
| Comparative Example 69 | (129) | 50 | 5.0 | 40 | 50 |
| Comparative Example 70 | (130) | 60 | 2.0 | 40 | 50 |
| Comparative Example 71 | (131) | 50 | 5.0 | 40 | 50 |

(continued)

| Example | Lithographic Printing Plate Precursor | Sensitivity ($mJ/cm^2$) | Printing Durability (x $10^4$ sheets) | On-Press Development Property (sheets) | Ink Receptivity (sheets) |
|---|---|---|---|---|---|
| Comparative Example 72 | (132) | 50 | 5.0 | 40 | 50 |
| Comparative Example 73 | (133) | 50 | 5.0 | 40 | 50 |
| Comparative Example 74 | (134) | 50 | 5.0 | 40 | 50 |
| Comparative Example 75 | (135) | 120 | 0.1 | 5 | 10 |

From the results shown in Table 2, it can be seen that a lithographic printing plate precursor of on-press development type which is excellent in the on-press development property and ink receptivity and exhibits excellent sensitivity and printing durability is obtained by using the lithographic printing plate precursor according to the invention.

Example 61 and Comparative Example 76

5. Preparation of Lithographic printing plate precursors (136) and (137)

Lithographic printing plate precursor (136) was prepared in the same manner as in Lithographic printing plate precursor (46) except for changing Coating solution (2) for image-recording layer in Lithographic printing plate precursor (46) to Coating solution (4) for image-recording layer shown below.

Lithographic printing plate precursor (137) was prepared in the same manner as in Lithographic printing plate precursor (67) except for changing Coating solution (2) for image-recording layer in Lithographic printing plate precursor (67) to Coating solution (4) for image-recording layer shown below.

<Coating solution (4) for image-recording layer>

Coating solution (4) for image-recording layer was prepared in the same manner as in Coating solution (2) for image-recording layer except for using 72 g of Aqueous dispersion (3) of polymer fine particle shown below in place of 20.0 g of Aqueous dispersion (1) of polymer fine particle used in Coating solution (2) for image-recording layer.

Preparation of Aqueous dispersion (3) of polymer fine particle

In a 200 ml three-neck flask equipped with a mechanical stirrer were charged 85 g of water, 0.3 g of sodium dodecylsulfate (SDS), 4.5 g of acrylonitrile and 0.5 g of styrene to completely dissolve. The system was substituted with nitrogen and nitrogen was flowed at a flow rate of 10 ml/min. After raising the temperature to 70°C, an aqueous potassium persulfate solution (containing 0.27 g of potassium persulfate and 10 g of water) was dropwise added thereto over a period of 2 hours with stirring at rotation speed of 300 rpm. After the completion of the dropwise addition, the mixture was stirred at 70°C for 3 hours and then the temperature was raised to 80°C, followed by stirring for 2 hours. Thus, Aqueous dispersion (3) of polymer fine particle of St/AN (10/90 in a weight ratio) was obtained. The particle size distribution of the polymer fine particle had the maximum value at the particle size of 125 nm. The solid content was 5.5% by weight.

6. Evaluation of Lithographic printing plate precursors (136) and (137)

Evaluation of Lithographic printing plate precursors (136) and (137) were conducted according to the evaluation method of lithographic printing plate precursor described above (Example 61 and Comparative Example 76). The results obtained are shown in Table 3. In Table 3, the results of Example 21 and Comparative Example 27 are also shown.

TABLE 3: Example (61) and Comparative Example (76) Evaluation Results of Printing

| | Lithographic Printing Plate Precursor | Sensitivity ($mJ/cm^2$) | Printing Durability (x $10^4$ sheets) | On-Press Development Property (sheets) | Ink Receptivity (sheets) |
|---|---|---|---|---|---|
| Example 21 | (46) | 50 | 5.0 | 10 | 5 |
| Example 61 | (136) | 50 | 5.0 | 15 | 10 |
| Comparative Example 27 | (67) | 50 | 5.0 | 40 | 30 |
| Comparative Example 76 | (137) | 50 | 5.0 | 60 | 50 |

From the results shown in Table 3, it can be seen that the ink receptivity is improved by incorporating a polyoxyalkylene structure into the polymer fine particle contained in the image-recording layer.

INDUSTRIAL APPLICABILITY

The lithographic printing plate precursor according to the invention is excellent in the on-press development property and ink receptivity and exhibits excellent sensitivity and printing durability, and can be favorably used in various printing fields.

## Claims

**1.** A lithographic printing plate precursor comprising: a support; an image-recording layer which contains (A) an infrared absorbing agent, (B) a radical polymerization initiator and (C) a radical polymerizable compound and in which an unexposed area can be removed by supplying printing ink and dampening water after exposure; and an overcoat layer in this order, **characterized in that** the overcoat layer contains at least two kinds of inorganic stratiform compounds having different crystal structures.

**2.** The lithographic printing plate precursor as claimed in Claim 1, wherein at least one kind of the inorganic stratiform compounds is a layered silicate compound.

**3.** The lithographic printing plate precursor as claimed in Claim 1 or 2, wherein at least two kinds of the inorganic stratiform compounds are layered silicate compounds in which layer structures composed of a tetrahedral sheet and an octahedral sheet are different from each other.

**4.** The lithographic printing plate precursor as claimed in Claim 3, wherein the layer structures composed of a tetrahedral sheet and an octahedral sheet in at least two kinds of the inorganic stratiform compounds are 1 : 1 type and 2 : 1 type.

**5.** The lithographic printing plate precursor as claimed in Claim 4, wherein the 1 : 1 type inorganic stratiform compound is a kaolin subgroup.

**6.** The lithographic printing plate precursor as claimed in Claim 4, wherein the 2 : 1 type inorganic stratiform compound is at least one kind selected from a swellable synthetic mica, a smectite group and a vermiculite group.

**7.** The lithographic printing plate precursor as claimed in any one of Claims 1 to 6, wherein the image-recording layer further contains (D) a binder polymer.

**8.** The lithographic printing plate precursor as claimed in Claim 7, wherein the binder polymer (D) is a copolymer having an alkylene oxide structure in its side chain.

**9.** The lithographic printing plate precursor as claimed in any one of Claims 1 to 8, wherein the image-recording layer further contains a polymer fine particle.

**10.** The lithographic printing plate precursor as claimed in Claim 9, wherein the polymer fine particle has a polyalkylene

oxide structure in its side chain.

**11.** The lithographic printing plate precursor as claimed in Claim 9 or 10, wherein the polymer fine particle contains a microcapsule or a Microgel.

**12.** A plate making method of a lithographic printing plate precursor comprising a step of exposing imagewise the lithographic printing plate precursor as claimed in any one of Claims 1 to 11 and a step of removing an unexposed area of the image-recording layer of the lithographic printing plate precursor by supplying oily ink and dampening water on a printing machine to initiate printing without subjecting any development processing to the exposed lithographic printing plate precursor.

**Patentansprüche**

**1.** Lithografiedruckplattenvorläufer, umfassend, in dieser Reihenfolge: einen Träger; eine Bildaufzeichnungsschicht, die (A) einen Infrarotabsorber, (B) einen Initiator der radikalischen Polymerisation und (C) eine radikalisch polymerisierbare Verbindung enthält und worin ein nicht-belichteter Bereich durch Zuführen von Drucktinte und Anfeuchtwasser nach Belichtung entfernt werden kann; und eine Überzugsschicht, **dadurch gekennzeichnet, dass** die Überzugsschicht mindestens zwei Arten von anorganischen Schichtverbindungen enthält, die verschiedene Kristallstrukturen aufweisen.

**2.** Lithografiedruckplattenvorläufer gemäß Anspruch 1, worin mindestens eine Art der anorganischen Schichtverbindungen eine Silikatschichtverbindung ist.

**3.** Lithografiedruckplattenvorläufer gemäß Anspruch 1 oder 2, worin mindestens zwei Arten der anorganischen Schichtverbindungen Silikatschichtverbindungen sind, worin die Schichtstrukturen, die aus einer tetraedrischen Lage und einer octaedrischen Lage aufgebaut sind, sich voneinander unterscheiden.

**4.** Lithografiedruckplattenvorläufer gemäß Anspruch 3, worin die Schichtstrukturen, die aus einer tetraedrischen Lage und einer octaedrischen Lage aufgebaut sind, in den zumindest zwei Arten der anorganischen Schichtverbindungen vom 1:1-Typ und vom 2:1-Typ sind.

**5.** Lithografiedruckplattenvorläufer gemäß Anspruch 4, worin die anorganische Schichtverbindung vom 1:1-Typ aus der Kaolin-Untergruppe ist.

**6.** Lithografiedruckplattenvorläufer gemäß Anspruch 4, worin die anorganische Schichtverbindung vom 2:1-Typ mindestens eine ist, ausgewählt aus quellfähigem synthetischem Glimmer, einer Smektitgruppe und eine Vermiculitgruppe.

**7.** Lithografiedruckplattenvorläufer gemäß irgendeinem der Ansprüche 1 bis 6, worin die Bildaufzeichnungsschicht ferner (D) ein Bindepolymer enthält.

**8.** Lithografiedruckplattenvorläufer gemäß Anspruch 7, worin das Bindepolymer (D) ein Copolymer ist, das in dessen Seitenkette eine Alkylenoxidstruktur aufweist.

**9.** Lithografiedruckplattenvorläufer gemäß irgendeinem der Ansprüche 1 bis 8, worin die Bildaufzeichnungsschicht ferner einen feinen Polymerpartikel enthält.

**10.** Lithografiedruckplattenvorläufer gemäß Anspruch 9, worin der feine Polymerpartikel eine Polyalkylenoxidstruktur in dessen Seitenkette aufweist.

**11.** Lithografiedruckplattenvorläufer gemäß Anspruch 9 oder 10, worin der feine Polymerpartikel eine Mikrokapsel oder ein Mikrogel enthält.

**12.** Plattenherstellungsverfahren für einen Lithografiedruckplattenvorläufer, umfassend einen Schritt zum bildweisen Belichten des Lithografiedruckplattenvorläufers gemäß irgendeinem der Ansprüche 1 bis 11 und einen Schritt zum Entfernen eines nicht-belichteten Bereichs der Bildaufzeichnungsschicht des Lithografiedruckplattenvorläufers durch Zuführen von öliger Tinte und Anfeuchtwasser auf einer Druckmaschine, um das Drucken zu beginnen, ohne

jegliche Entwicklungsverarbeitung an dem belichteten Lithografiedruckplattenvorläufer durchzuführen.

## Revendications

1. Précurseur de plaque d'impression lithographique comprenant : un support ; une couche d'enregistrement d'image qui contient (A) un agent absorbant l'infrarouge, (B) un initiateur de polymérisation radicalaire et (C) un composé polymérisable par voie radicalaire et dans lequel une zone non exposée peut être retirée en fournissant de l'encre d'impression et de l'eau de mouillage après l'exposition ; et une couche de revêtement dans cet ordre, **caractérisé en ce que**
la couche de revêtement contient au moins deux types de composés stratiformes inorganiques présentant des différentes structures cristallines.

2. Précurseur de plaque d'impression lithographique tel que revendiqué dans la revendication 1, dans lequel au moins un type des composés stratiformes inorganiques est un composé de silicate stratifié.

3. Précurseur de plaque d'impression lithographique tel que revendiqué dans la revendication 1 ou 2, dans lequel au moins deux types des composés stratiformes inorganiques sont des composés de silicate stratifié dans lesquels des structures stratifiées composées d'une feuille tétraédrique et d'une feuille octaédrique sont différentes l'une de l'autre.

4. Précurseur de plaque d'impression lithographique tel que revendiqué dans la revendication 3, dans lequel les structures stratifiées composées d'une feuille tétraédrique et d'une feuille octaédrique dans l'au moins deux types de composés stratiformes inorganiques sont de type 1 : 1 et de type 2 : 1.

5. Précurseur de plaque d'impression lithographique tel que revendiqué dans la revendication 4, dans lequel le composé stratiforme inorganique de type 1 : 1 est un sous-groupe kaolin.

6. Précurseur de plaque d'impression lithographique tel que revendiqué dans la revendication 4, dans lequel le composé stratiforme inorganique de type 2 : 1 est au moins un type choisi parmi un mica synthétique susceptible de gonfler, un groupe de la smectite, et un groupe de la vermiculite.

7. Précurseur de plaque d'impression lithographique tel que revendiqué dans l'une quelconque des revendications 1 à 6, dans lequel la couche d'enregistrement d'image contient en outre (D) un polymère liant.

8. Précurseur de plaque d'impression lithographique tel que revendiqué dans la revendication 7, dans lequel le polymère de liaison (D) est un copolymère ayant une structure d'oxyde d'alkylène dans sa chaîne latérale.

9. Précurseur de plaque d'impression lithographique tel que revendiqué dans l'une quelconque des revendications 1 à 8, dans lequel la couche d'enregistrement d'image contient en outre une particule fine de polymère.

10. Précurseur de plaque d'impression lithographique tel que revendiqué dans la revendication 9, dans lequel la particule fine de polymère a une structure d'oxyde de polyalkylène dans sa chaîne latérale.

11. Précurseur de plaque d'impression lithographique tel que revendiqué dans la revendication 9 ou 10, dans lequel la particule fine de polymère contient une microcapsule ou un microgel.

12. Procédé de fabrication de plaque d'un précurseur de plaque d'impression lithographique comprenant une étape consistant à exposer sous forme d'image le précurseur de plaque d'impression lithographique tel que revendiqué dans l'une quelconque des revendications 1 à 11 et une étape consistant à retirer une zone non exposée de la couche d'enregistrement d'image du précurseur de plaque d'impression lithographique en fournissant de l'encre huileuse et de l'eau de mouillage sur une machine d'impression pour initier une impression sans soumettre le précurseur de plaque d'impression lithographique exposé à aucun traitement de développement.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1518672 A
- JP 2001277740 A
- JP 2001277742 A
- JP 2002287334 A
- US 20030064318 A
- JP 2005271284 A
- JP 2005119273 A
- US 3458311 A
- JP 55049729 B
- JP 3298317 B
- JP 2008195018 A
- JP 2001133969 A
- JP 2002023360 A
- JP 2002040638 A
- JP 8108621 A
- JP 61166544 A
- JP 2002328465 A
- US 4069055 A
- JP 4365049 A
- US 4069056 A
- EP 104143 A
- US 20080311520 A
- JP 2150848 A
- EP 370693 A
- EP 390214 A
- EP 233567 A
- EP 297443 A
- EP 297442 A
- US 4933377 A
- US 4760013 A
- US 4734444 A
- US 2833827 A
- DE 2904626
- DE 3604580
- DE 3604581
- JP 2005329708 A
- JP 9123387 A
- JP 9131850 A
- JP 9171249 A
- JP 9171250 A
- EP 931647 A
- JP 2006297907 A
- JP 2007050660 A
- JP 2008284817 A
- JP 2006091479 A
- JP 10282679 A
- JP 2304441 A
- JP 2005125749 A
- JP 2006188038 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP 6035174 A


### Non-patent literature cited in the description


- *Homepage of The Clay Science Society of Japan, http://wwwsoc.nii.ac.jp/cssj2/seminar1/section01/text.html*
- **MASAHIRO MAENO.** Sokogasiritai Nendo no Kagaku. The Nikkan Kogyo Shimbun, Ltd, 1993
- **HARUO SHIROUZU.** Nendo Kobutsugaku. Asakura Publishing Co., Ltd, 1988
- *Clays and Clay Minerals,* 1975, vol. 23, 477
- *J. Inorg. Nucl. Chem.,* 1981, vol. 43, 1343
- *Inorg. Chem.,* 1976, vol. 15, 2811
- **S. I. SCHLESINGER.** *Photogr. Sci. End.,* 1974, vol. 18, 387
- **T. S. BAL et al.** *Polymer,* 1980, vol. 21, 423
- **J. V. CRIVELLO et al.** *Macromolecules,* 1977, vol. 10 (6), 1307
- **J. V . CRIVELLO et al.** *J. Polymer Sci., Polymer Chem. Ed.,* 1979, vol. 17, 1047
- **C. S. WEN et al.** *Teh, Proc. Conf. Rad. Curing ASIA,* October 1988, 478